# EUROPEAN PATENT APPLICATION

(11) **EP 4 436 048 A1**
(43) Date of publication of application: **25.09.2024**
(21) Application number: 23163954.3
(22) Date of filing: 24.03.2023
(51) Int. Cl.: H03M 7/30, H04N 19/172

(54) **DATA COMPRESSION WITH CONTROLLABLE SEMANTIC LOSS**

(71) Applicant: Koninklijke Philips N.V., 5656 AG Eindhoven (NL)
(72) Inventor: Davies, Rob, Eindhoven (NL); Garcia Morchon, Oscar, Eindhoven (NL); Cronin, Harry Michael, Eindhoven (NL); Duffy, David, Eindhoven (NL); Walker, Nicholas, Eindhoven (NL); Kroon, Bart, Eindhoven (NL); Varekamp, Christiaan, Eindhoven (NL)
(74) Representative: Philips Intellectual Property & Standards

(57) **Abstract**

This invention describes apparatuses/methods for data compression/decompression, wherein input observation data is classified into types of semantic objects according to one or more criteria and a compression technique is applied to the object types based on their ease of reconstruction via a compression model to obtain compressed data. The classification may be performed based on the performance of the compression model. A suitable descriptive prompt may be generated, e.g., based on a textual inversion technique, for a data object belonging to a data object type that can be well reconstructed. Furthermore, the invention may be applied for personalized data compression/construction/decompression/reconstruction, wherein an encoder/decoder takes a suitable personalized descriptive prompt (or program) and/or a personalized reconstruction model and/or a personalized policy to generate personalized content according to the user's preferences and/or profile.

## Description

### FIELD OF THE INVENTION

This invention relates to a data compression system for data transfer (such as low latency communication between remote users), which can be implemented in (but is not limited to) augmented/virtual reality (AR/VR) or metaverse applications that can be defined as a virtual-reality space in which users can interact with a computer-generated environment and/or other users.

### BACKGROUND OF THE INVENTION

Within the 3GPP Technical Specification Group Service and System Aspects (TSG SA), the main objective of 3GPP TSG SA WG1 (SA1) is to consider and study new and enhanced services, features, and capabilities of the 5G system and identify any corresponding stage 1 requirements to be met by 3GPP specifications. These service requirements are documented in normative specifications under SA1 responsibility. A related study is TR 22.847, "Study on supporting tactile and multi-modality communication services (TAMMCS)*".* This study includes eight use cases and related requirements for the so-called "tactile internet" (Tl).

The International Telecommunication Union (ITU) defines the TI as an internet network that combines ultra-low latency with extremely high availability, reliability and security. The mobile internet allowed exchange of data and multimedia content on the move. The next step is the internet of things (IoT) which enables interconnection of smart devices. The TI is the next evolution that will enable the control of the IoT in real time. It will add a new dimension to human-to-machine interaction by enabling tactile and haptic sensations, and at the same time revolutionise the interaction of machines. TI will enable humans and machines to interact with their environment, in real time, while on the move and within a certain spatial communication range.

IEEE publication P1918.1, "Tactile Internet: Application Scenarios, Definitions and Terminology, Architecture, Functions, and Technical Assumptions*"* demands that cellular 5G communication systems shall support a mechanism to assist synchronisation between multiple streams (e.g., haptic, audio and video) of a multi-modal communication session to avoid negative impact on the user experience. Moreover, 5G systems shall be able to support interaction with applications on user equipment (UE) or data flows grouping information within one tactile and multi-modal communication service and to support a means to apply 3rd party provided policies for flows associated with an application. The policy may contain a set of UEs and data flows, an expected quality of service (QoS) handling and associated triggering events, and other coordination information.

In scenarios such as augmented or virtual reality (AR/VR) or metaverse or communications, a virtual-reality space in which users can interact with a computer-generated environment and other users, it is of key importance to compress the exchanged representations of the users and environment in such a way that the rendering of the involved user representations and/or environments and/or virtual spaces is as realistic as feasible.However, after the rendering process, there is a problem that dependencies and/or concepts and/or other linking information of the involved user representations and/or environments and/or virtual spaces are lost by the compression, which is called semantic loss.

Furthermore, in scenarios such as video streaming, users receiving the video stream (or other type of data) are willing to be offered personalized content in such a way that they enjoy the video since it fully fits its taste.

However, current video streaming platforms are not capable of personalizing the content, e.g., one may opt for series A, B, C,... but there is a single version of series A, B, or C. If series A is chosen, all users watch exactly the same content. It is therefore desirable to offer a way to control, trade-off or optimize semantic loss (and certainly not for sub-sections of an input, like specific parts of an image) and to provide consistency of placement of regenerated objects both in space (e.g., in an image), and in time (e.g., in video or audio). It is also therefore desirable to offer a way to offer personalized content.

### SUMMARY OF THE INVENTION

It is an object of the present invention to address above desirable features by enabling high-quality interactions with reduced communication overhead and personalized data generation.

This object is achieved by an apparatus as claimed in claim 1 and 9, by a system as claimed in claim 15, by a method as claimed in claim 21 and 22, by a computer program product as claimed in claim 23, and by a bit stream as claimed in claim 24.

According to a first aspect (directed to a compression or encoding side of a compression system, e.g., a transmitting device or transmitter or computer device), an apparatus is provided, which is configured to segment input data to produce instances relating to identified semantic objects according to one or more criteria; and to apply a compression technique to the identified semantic objects. In an example, the input observation data may as well be computer-generated data e.g. for computer games or video streaming.

According to a second aspect (directed to a decompression or decoding side of a compression system, e.g., a receiving device or receiver or computer device), an apparatus is provided, which is configured to receive compressed semantic objects and to apply a decompression technique based on the compression model and a type of the received compressed semantic data objects to obtain decompressed data.

According to a third aspect, a system comprises a transmitting device comprising an apparatus of the first aspect, and a receiving device comprising an apparatus of the second aspect, wherein the transmitting device is configured to share the compression model with the receiving device, and wherein the shared compression model is determined or updated based on a reconstruction performance and/or receiver preferences.

According to a fourth aspect (directed to a compression or encoding side of a compression system), a method comprises:
segmenting input observation data to produce instances relating to identified semantic objects according to one or more criteria; and
applying a compression technique to the identified semantic objects.

According to a fifth aspect (directed to a decompression or decoding side of a compression system), a method comprises:
receiving compressed semantic objects; and
applying a decompression technique based on a compression model and a type of the received compressed semantic objects to obtain decompressed data, wherein the compression model and/or compressed semantic objects depend on at least one of decompression performance requirements, semantic loss requirements, and user preference requirements.

According to a sixth aspect, a computer program product is provided, which comprises code means for producing the steps of the method of the third aspect or the fourth aspect when run on a computer device.

According to a seventh aspect, a bit stream is provided, that is generated by the method of the third aspect and comprises at least one descriptive prompt representing a compressed semantic object belonging to a data object type that can be represented or reconstructed by means of the descriptive prompt and a compression model.

Accordingly, a compression system for control and negotiation of semantic loss applicable to generative compression techniques is proposed, which uses the insight that different objects in an observed scene will contribute notably differently to overall semantic loss to enable a per-object loss optimization function. Thereby, semantic loss can be optimized with greater control than known systems by operating on a per-object level.

Data compression can thus be achieved by classifying input data into one or multiple types of data objects according to one or more criteria and applying a compression technique to each of the object types to obtain compressed data. The compressed data can then be decompressed by applying a decompression technique to each of the input compressed data object types to obtain decompressed data.

Moreover, input data can be analyzed to determine whether at least one selected part of the input data can be compressed using a first compression scheme according to at least one first criteria. Upon such determination, the at least one selected part of the input data can be compressed using the first compression scheme, while any remaining part of the input data can be compressed using at least one different compression scheme.

The semantic loss can be improved on-the-fly by incorporating consistency data generated from a comparison of a generated scene to reality, either prior to or after transmission or storage. Moreover, spatial and temporal consistency of regenerated scenes can be improved by using per-object and global consistency data.

The semantic loss can be negotiated between an encoder and a third party (such as a network function) to co-optimize bandwidth and realism. A shared reconstruction model can be dynamically updated to account for successfully learned prompts which are available to both transmitter (encoder) and receiver (decoder), reducing bandwidth for future transmissions of the same object.

In a predictive mode, prompts can be generated before their relevant observations, but still offering control of semantic loss.

According to a first option that can be combined with any one of the first to seventh aspects, a descriptive prompt may be generated for a semantic object belonging to a data object type that can be represented or reconstructed with no more than a minimal semantic loss by means of the descriptive prompt and the compression model. Thereby, the mere descriptive prompt needs to be transmitted instead of the semantic object, so that substantial data compression can be achieved.

According to a second option that can be combined with the first option or any one of the first to seventh aspects, wherein an image may be synthesized using the generated descriptive prompt, instance segmentation may be run on the synthesized image, at least one of a crop parameter, a translation parameter and a scale parameter may be determined, and the determined parameter may be output together with the descriptive prompt.. Thereby, the original image may be reconstructed from the synthesized image by using the additionally output parameter(s).

According to a third option that can be combined with the first or second option or any one of the first to seventh aspects, the compression technique may be based on at least one of an ease of reconstruction of the identified semantic objects, semantic-loss requirements, personalization requirements, and compression needs, via a compression model. Thereby, a flexible object-oriented compression technique can be provided.

According to a fourth option that can be combined with any one of the first to third options or any one of the first to seventh aspects, temporal data association of generated descriptive prompts may be performed for frames of the input observation data over time, and parameters of a global motion model may be determined for each instance associated with a generated descriptive prompt. Thereby, motion-related reconstruction can be simplified by using the global motion model.

According to a fifth option that can be combined with any one of the first to fourth options or any one of the first to seventh aspects, a data object belonging to a data object type that cannot be represented or reconstructed with minimal semantic loss by means of a descriptive prompt and the compression model may be compressed by at least one of generating an estimated descriptive prompt suitable to retain sufficient semantic content for a given context; developing a descriptive prompt based on textual inversion guided by the data object; and using a conventional compression technique. Thereby, the compression amount of remaining non-easy-to-reconstruct areas of the observed scene can be flexibly adapted to the data object type.

According to a sixth option that can be combined with any one of the first to fifth options or any one of the first to seventh aspects, compressed data objects may be labelled according to the used compression technique and/or reconstruction model. This facilitates decompression/decoding at the receiving device.

According to a seventh option that can be combined with any one of the first to sixth options or any one of the first to seventh aspects, the observation data may comprise at least one of image, video, audio and haptic information. Thereby, the proposed compression scheme can be implemented for all aspects of metaverse applications.

According to an eighth option that can be combined with any one of the first to seventh options or any one of the first to seventh aspects, a sensor may be used to obtain the input observation data. Thus, the proposed compression scheme can be applied to all types of sematic objects in connection with any measurable or detectable scene.

According to a ninth option that can be combined with any one of the first to eighth options or any one of the first to seventh aspects, a compression policy may be configured or negotiated by/with a communication manager, wherein the compression policy determines at least one of an allowed quantity of semantic loss, a desired compression ratio, a desired computational overhead, a desired storage overhead and a desired communication overhead. Thereby, the selection of the compression scheme for identified object types can be controlled by the compression policy and a network-based control of the compression policy can be implemented. In an example of the eighth option, the decompression technique may rely on at least one of a personalized compression model, a personalized policy, and a personalized prompt to obtain personalized decompressed data.

According to a tenth option that can be combined with any one of the first to ninth options or any one of the first to seventh aspects, at least one of the compressed semantic objects may be decompressed based on a shared reconstruction model and a descriptive prompt. Thus, compression at the receiving end can be achieved by simply forwarding a reference to the compression model.

According to an eleventh option that can be combined with any one of the first to tenth options or any one of the first to seventh aspects, the (shared) compression model may be determined and updated based on a reconstruction performance. Thereby, a feedback loop for controlling the shared compression model can be established to optimize the reconstruction performance.

According to a twelfth option that can be combined with any one of the first to eleventh options or any one of the first to seventh aspects, the compression model may be retrieved from a compression model repository. Thus, a flexibility of the proposed object-based compression model can be enhanced by providing access to a compression model repository.

According to a thirteenth option that can be combined with any one of the first to twelfth options or any one of the first to seventh aspects, the descriptive prompt may be generated predictively. Thereby, previous developments of the observed scene can be assessed to predict object types or movements and predict corresponding descriptive prompts for improved compression performance.

According to a fourteenth option that can be combined with any one of the first to thirteenth options or any one of the first to seventh aspects, decompressed data that has been decompressed based on the predicted descriptive prompt may be compared with the input observation data to determine a correction factor. Thus, the compression factor can be used as a measure for the prediction performance.

According to a fifteenth option that can be combined with any one of the first to fourteenth options or any one of the first to seventh aspects, the correction factor may be used to re-train a shared reconstruction model. Thereby, the shared reconstruction model can be adapted to the compression history to improve future compression performance.

According to a sixteenth option that can be combined with any one of the first to fifteenth options or any one of the first to seventh aspects, the correction factor may be transmitted to a receiver. Thus, the correction factor can be transmitted together with the predictive prompt to reduce semantic loss while keeping a good compression performance.

According to a seventeenth option that can be combined with any one of the first to sixteenth options or any one of the first to seventh aspects, at least one of the compressed semantic objects may be decompressed based on a shared reconstruction model and a descriptive prompt. Thus, the decompression side merely requires a reference to the shared reconstruction model for proper reconstruction of the observed scene based on the descriptive prompt.

According to an eighteenth option that can be combined with any one of the first to seventeenth options or any one of the first to seventh aspects, a decompression policy may be provided at the decompression side. Thus, the decompression can be controlled based on the policy.

According to a nineteenth option that can be combined with any one of the first to eighteenth options or any one of the first to seventh aspects, the decompression policy may be negotiated with or configured by a communication manager. Thereby, the decompression performance can be controlled from the network side.

According to a twentieth option that can be combined with any one of the first to nineteenth options or any one of the first to seventh aspects, the compression model may be shared with a transmitting device. Thus, compression at the receiving end can be achieved by simply forwarding a reference to the compression model.

According to a twenty-first option that can be combined with any one of the first to twentieth options or any one of the first to seventh aspects, a received descriptive prompt may be used for predictive decompression. Thereby, previous compression developments can be assessed to accelerate the decompression process.

According to a twenty-second option that can be combined with any one of the first to twenty-first options or any one of the first to seventh aspects, the predictive decompression may be based on communication parameters such as latency with a transmitter. Thus, the decompression can be adapted to the communication performance.

According to a twenty-third option that can be combined with any one of the first to twenty-second options or any one of the first to seventh aspects, predicted decompressed data may be compared with the obtained decompressed data to determine a correction factor. Thereby, the performance of the predicted decompression can be measured and a real-time correction can be implemented.

According to a twenty-fourth option that can be combined with any one of the first to twenty-third options or any one of the first to seventh aspects, the correction factor may be transmitted to a transmitter from which the compressed semantic objects have been received. Thereby, a correction can be performed at the transmission end, so that a better match of the predicted decompression can be achieved.

According to a twenty-fifth option that can be combined with any one of the first to twenty-fourth options or any one of the first to seventh aspects, a correction factor may be received from a transmitter from which the compressed semantic objects have been received, and the correction factor may be used to correct the obtained decompressed data. Thereby, a correction can be performed at the receiving end, so that a better match of the decompression can be achieved.

According to a twenty-sixth option that can be combined with any one of the first to twenty-fifth options or any one of the first to seventh aspects, an image may be synthesized using the generated descriptive prompt, instance segmentation is run on the synthesized image, at least one of a crop parameter, a translation parameter and a scale parameter is determined, and the determined parameter is output together with the descriptive prompt. Thereby, multiple objects can be dealt with.

According to a twenty-seventh option that can be combined with any one of the first to twenty-sixth options or any one of the first to seventh aspects, temporal data association of generated descriptive prompts is performed for frames of the input observation data over time, and parameters of a global motion model are determined for each instance associated with a generated descriptive prompt. Thus, motion of a camera or other sensor device can be considered during scene observation.

According to a twenty-eighth option that can be combined with any one of the first to twenty-seventh options or any one of the first to seventh aspects, a semantic loss may be determined based on an instance rate distortion function, wherein a total loss may be summed over a plurality of semantic objects identified in the input observation data, and wherein an object loss may consist of an object rate and an object distortion which depends on object color and texture parameters. Thus, a per-object instance rate distortion can be considered.

According to a twenty-ninth option that can be combined with any one of the first to twenty-eighth options or any one of the first to seventh aspects, a receiving device may receive a personalized (de)compression model wherein the receiving device may have received such a personalized model (1) by signalling its preferences to the transmitting device or (2) once the transmitting devices has determined that the model fits the preferences of the receiving device.

According to a thirtieth option that can be combined with any one of the first to twenty-ninth options or any one of the first to seventh aspects, a transmitting device may be capable of at least one creating and/or editing content based on a compression model and an interpreted programming language and sharing said content with at least a receiving device.It shall be understood that the apparatus of claim 1 and 9, the system of claim 15, the method of claim 21 and 22, the computer program product of claim 23 and the bit stream of claim 24 may have similar and/or identical embodiments, in particular, as defined in the dependent claims.

It shall be understood that a preferred embodiment of the invention can also be any combination of the dependent claims or above embodiments with the respective independent claim.

These and other aspects of the invention will be apparent from and elucidated with reference to the embodiments described hereinafter.

### BRIEF DESCRIPTION OF THE DRAWINGS

In the following drawings:
Figs. 1A and 1B schematically show block diagrams of alternative network architectures for a metaverse implementation in a cellular network;
Fig. 2 schematically shows a state diagram representing the operation of an exemplary system implementing a metaverse application;
Fig. 3 schematically shows an exemplary metaverse implementation;
Fig. 4 schematically shows a block diagram of a network architecture for implementing various embodiments;
Fig. 5 schematically shows a block diagram of different layers involved in a compression system according to various embodiments;
Fig. 6 schematically shows a flow diagram of a compression and decompression process according to various embodiments using the different layers of Fig. 5;
Fig. 7 schematically shows flow diagrams of different processes involved in a compression and decompression process according to various embodiments; and
Fig. 8 schematically shows processing steps and outputs of an exemplary embodiment.

### DETAILED DESCRIPTION OF EMBODIMENTS

Embodiments of the present invention are now described based on a cellular communication network environment, such as 5G. However, the present invention may also be used in connection with other wireless technologies in which TI or metaverse applications are provided or can be introduced. The present invention may also be applicable to other applications such as video streaming services, video broadcasting services, or data storage.

Throughout the present disclosure, the abbreviation "gNB" (5G terminology) or "BS" (base station) is intended to mean a wireless access device such as a cellular base station or a WiFi access point or a ultrawide band (UWB) personal area network (PAN) coordinator. The gNB may consist of a centralized control plane unit (gNB-CU-CP), multiple centralized user plane units (gNB-CU-UPs) and/or multiple distributed units (gNB-DUs). The gNB is part of a radio access network (RAN), which provides an interface to functions in the core network (CN). The RAN is part of a wireless communication network. It implements a radio access technology (RAT). Conceptually, it resides between a communication device such as a mobile phone, a computer, or any remotely controlled machine and provides connection with its CN. The CN is the communication network's core part, which offers numerous services to customers who are interconnected via the RAN. More specifically, it directs communication streams over the communication network and possibly other networks.

Furthermore, the terms "base station" (BS) and "network" may be used as synonyms in this disclosure. This means for example that when it is written that the "network" performs a certain operation it may be performed by a CN function of a wireless communication network, or by one or more base stations that are part of such a wireless communication network, and vice versa. It can also mean that part of the functionality is performed by a CN function of the wireless communication network and part of the functionality by the base station.

Moreover, the term "metaverse" is understood as referring to a persistent shared set of interactable spaces, within which users may interact with one another alongside mutually perceived virtual features (i.e., augmented reality (AR)) or where those spaces are entirely composed of virtual features (i.e., virtual reality (VR)). VR and AR may generally be referred to as "mixed reality" (MR).

Additionally, the term "data" is understood as referring to a representation according to a known or agreed format of information to be stored, transferred or otherwise processed. The information may particularly comprise one or more channels of audio, video, image, haptic, motion or other form of multimedia information that may be synchronized. Such multimedia information may be derived from sensors (e.g., microphones, cameras, motion detectors, etc.) or may be partially or wholly synthesized (e.g., live actor in front of a synthetic background).

The term "data object" is understood as referring to one or more sets of data according to the above definition optionally accompanied by one or more data descriptors that provide extra semantic information about the data that influences how it should be processed at the transmitter and at the receiver. Data descriptors may be used to describe, for example, how the data is classified by a transmitter and how it should be rendered by a receiver. By way of example, data representing an image or a video sequence may be broken down into a set of data objects that collectively describe the full image or video and which may be individually processed (e.g., compressed) substantially independently of other data objects and in a manner optimal for the object and its semantic context. As a further example, a content program (as described later in some embodiments) may also be understood as a data object (e.g., a compressed semantic object).

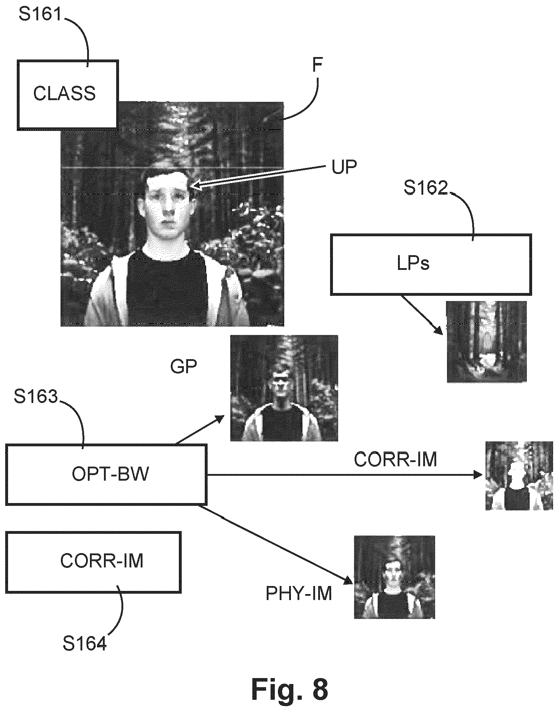

Further, the term "data object classification" is understood as referring to a process in which data is divided or segmented into multiple data objects. For instance, an image might be divided into multiple parts, e.g., a forest in the background and a person in the foreground (e.g., as exemplified later in connection with Fig. 8). Data object classification criteria are used to classify a data object. In this disclosure, such criteria may include at least one of a measure of semantic content of a data object, a context of the data object, a class of compression technique best suited to retain sufficient semantic content for a given context and so on.

In addition, a "compression technique" is understood as referring to a method of reducing the size of data so that its transmission or storage is more efficient. For instance, a method of removing redundant data or data that is considered semantically imperceptible to the end user and efficiently encoding the remaining data such that it is possible to reconstruct a faithful or semantically near-faithful representation of the original data.

Furthermore, a "compression or reconstruction model" is understood as referring to a repository of tools and data objects that can be used to assist data compression and reconstruction. For example, the model may comprise algorithms used in the analysis and compression of data objects or may comprise data objects that can be used as the basis of a generative compression technique. Advantageously, the model may be shared or possessed by a transmitter and a receiver and/or may be updated or optimized according to a semantic content of the data being transferred.

It is noted that throughout the present disclosure only those blocks, components and/or devices that are relevant for the proposed data distribution function are shown in the accompanying drawings. Other blocks have been omitted for reasons of brevity. Furthermore, blocks designated by same reference numbers are intended to have the same or at least a similar function, so that their function is not described again later.

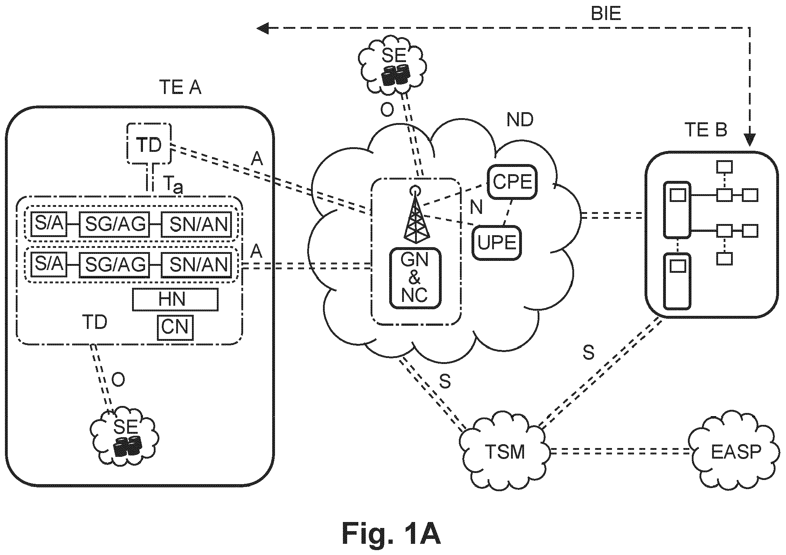

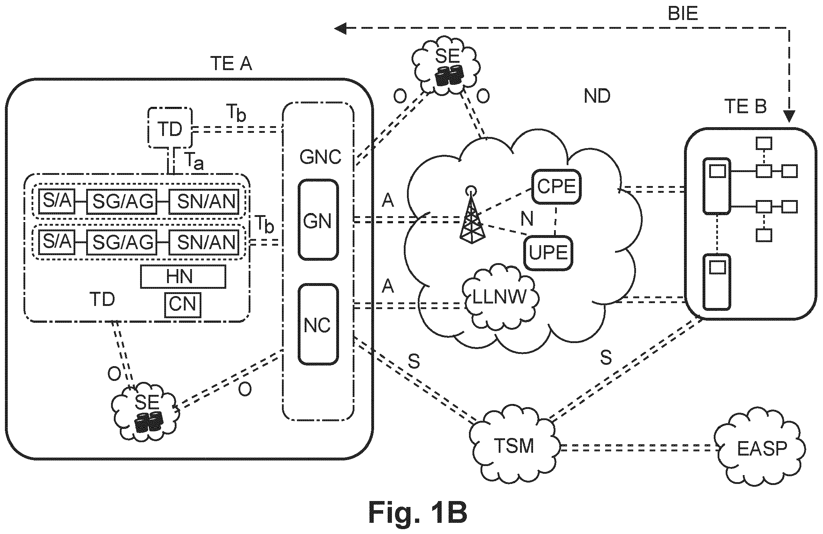

Figs. 1A and 1B schematically show network architectures considered for implementing a metaverse (e.g., IEEE P1918.1 architecture). The architectures comprise an actuator gateway (AG), an actuator node (AN), a controller node (CN), a control plane entity (CPE), a gateway node (GN, wherein GNC corresponds to GN & CN), a human-system interface node (HN), a network controller (NC), a sensor/actuator (S/A), a computing and storage entity (SE), a sensor gateway (SG), a sensor node (SN), a tactile device (TD), a tactile edge (TE), a tactile service manager (TSM), a user plane entity (UPE), an access interface (A), a first tactile interface Ta (TD-to-TD communication), a second tactile interface Tb (TD-to-GNC communications), an open interface (O), a service interface (S), a network side (N), a network domain (ND), a bidirectional information exchange (BIE), an external application service provider (EASP), and a dedicated low latency network (LLNW).

The architectures of Figs. 1A and 1B provide an overall communication architecture defined in a generic manner capable of running over/on any network, including 5G. They cover various modes of interconnectivity network domains between two TEs (TE A, TE B). Each TE consists of one or multiple TDs, where TDs in TE A communicate information, e.g., tactile/haptic, with TDs in TE B through the ND, to meet the requirements of a given TI use case. The ND can be either a shared wireless network (e.g., 5G radio access and core network), shared wired network (e.g., Internet core network), dedicated wireless network (e.g., point-to-point microwave or millimeter wave link), or dedicated wired network (e.g., point-to-point leased line or fiber optic link). Each TD can support one or multiple of the functions of sensing, actuation, haptic feedback, or control via one or multiple corresponding entities. The S or A entity refers to a device that performs sensing or actuation functions, respectively, without networking module. The SN or AN refers to a device that performs sensing or actuation functions, respectively, with an air interface network connectivity module. In order to connect S to SN or A to AN, the SG or AG entity should be used, respectively. These gateways provide a generic interface to connect to third-party sensing and actuation devices and another interface to connect to SNs and ANs. A TD can also serve as the HN, which can convert human input into haptic output, or as the CN, which runs control algorithms for handling the operation of a system of SNs and ANs, with the necessary network connectivity module.

The GN is an entity with enhanced networking capabilities that reside at the interface between the TE and the ND and is mainly responsible for user plane data forwarding. The GN is accompanied by the NC that is responsible for control plane processing including intelligence for admission and congestion control, service provisioning, resource management and optimization, and connection management in order to achieve the required QoS for the TI session. The GN and CN (together labelled as GNC) can reside either in the TE side (as shown in Fig. 1A) or in the ND side (as shown in Fig. 1B), depending on the network design and configuration. The GNC is a central node as it facilitates interoperability with the various possible network domain options, which is essential for compatibility with other emerging standards such as the 3GPP 5G NR specifications. Allowing the GNC to reside in the ND, for example under 5G, intends to support the option of absorbing its functionality into management and orchestration functionalities already therein. In Figs. 1A and 1B, the ND is shown to be composed of a radio access point or base station connected logically to CPEs and UPEs in the network core.

A user in a region of interest (ROI) is surrounded by a set of TDs linked to a TE. A TD might comprise rendering actuators and/or sensors. Rendering actuators have the task of creating a metaverse environment around the user and might be VR glasses, a 3D television (TV), a holographic device, etc. A sensor TD is a device in charge of capturing the actions and/or environment of the user and might include video cameras, audio devices such as microphone, haptic sensors, etc. In general, a TD might be a UE in terms of a 5G system.

The TDs in a ROI may be connected to the TE of the user, e.g., by means of wires or wirelessly. In the wireless case, the UEs may be connected to a base station such as a 5G gNB or to a WiFi access point. The networking infrastructure and computational resources of the TE are either co-located in the ROI or located (distance less than a maximum edge distance) in a close edge server to ensure a fast response.

To assist the implementation of the following embodiments, at least one of three communication functionalities may be introduced. First, latency-based flow synchronization (LBFS) may be provided, which is a functionality running in a device in the TE. It could also be deployed in a receiving TD capable of determining communication parameters with sending TDs (or TS) and synchronizing communication flows based on those communication parameters, in particular, the relative latency between TDs (or TEs). Second, an edge application at a TE may be configured to run a latency-dependent configurable predictive model (LDCPM) of the environment/persons in the metaverse session in a different TE. Third, a model management and configuration functionality may be provided, that is capable of registering a generic model of an ROI and/or device and/or person in a TE, storing it in a data base, and deploying a re-configured LDCPM upon determining the communication parameters.

Another pioneering node in the architectures of Figs. 1A and 1B is the SE that provides both computing and storage resources for improving the performance of the TEs and meeting the delay and reliability requirements of the E2E communications. The SE will run advanced algorithms, employing AI techniques, among others, to offload processing operations that are too resource and/or energy intensive to be done in the TD (e.g., haptic rendering, motion trajectory prediction, and sensory compensation). The goal is to enable the perception of real-time connectivity using predictive analytics while overcoming the challenges and uncertainties along the path between the source and destination TDs, dynamically estimate network load and rate variations overtime to optimize resource utilization, and to allow sharing of learned experiences about the environment among different TDs. On the other hand, the SE will also provide intelligent caching capabilities which can be very impactful in reducing the E2E traffic load and thus reducing the data transmission delays. The SE can reside locally within the TE to enhance the response rate for requests from TDs or GNC, and/or it can reside remotely in the cloud while providing services to the TEs and the ND. Moreover, the SE can be either centralized or distributed. Each of these options has its own pros and cons in terms of delay, reliability, capabilities, cost, and practical feasibility. The communications between the two TEs can be unidirectional or bidirectional, can be based on client-server or peer-to-peer models and can belong to any of the above-mentioned use cases with their corresponding reliability and delay requirements. To this end, the TSM plays a critical role in defining the characteristics and requirements of the service between the two TEs and in disseminating this information to key nodes in the TE and the ND. The TSM will also support functions such as registration and authentication and will provide an interface to EASPs of the Tl.

The A interface provides connectivity between the TE and the ND. It is the main reference point for the user plane and the control plane information exchange between the ND and the TE. Depending on the architecture design, the A interface can be either between the TD and the ND or between the GNC and the ND. Furthermore, the T interface provides connectivity between entities within the TE. It is the main reference point for the user plane and the control plane information exchange between the entities of the TE. The T interface is divided into two sub-interfaces Ta and Tb to support different modes of TD connectivity, whereby the Ta interface is used for TD-to-TD communications and the Tb interface is used for TD-to-GNC communications when the GNC resides in the TE. Additionally, the O interface provides connectivity between any architectural entity and the SE, and the S interface provides connectivity between the TSM and the GNC. The S interface carries control plane information . Finally, the N interface refers to any interface providing internal connectivity between ND entities. This is normally covered as part of the network domain standards and can include sub-interfaces for both user plane and control plane entities.

Two broad categories of haptic information may be implemented, namely, tactile or kinesthetic, which may be combined. Tactile information refers to the perception of information by various mechanoreceptors of the human skin, such as surface texture, friction, and temperature. Kinesthetic information refers to the information perceived by the skeleton, muscles, and tendons of the human body, such as force, torque, position, and velocity.

A first differentiating aspect of TI and related standards compared with 5G ultra reliable low latency communication (URLLC, ITU-R M.2083) relates to the fact that the TI must be developed in a way that can realize its requirements over longer distances than the 150 km (or 100 km in fiber) separation for a round-trip due to a propagation time of 1 ms. Such capability can be achieved through network side support functions built into the TI architecture, as envisioned through the standards work in IEEE 1918.1. These functions could, for example, model the remote environment using artificial intelligence (Al) approaches and could in some cases also partly or totally be present at the TI end device (i.e., the client of the TI/haptic information).

A second differentiating aspect relates to the fact that TI leads to an application with unique characteristics implied by that application and with the expectation that the application can be deployed as an overlay network on top of a network or combination of networks. It is not intended to apply in the context of 5G URLLC as the underlying communication means only.

Moreover, in the above architectures of Figs. 1A and 1B, data streams, e.g.,haptic feedback, must be synchronized as well and users expect that they should "feel" or "experience" visually depicted events as they occur, regardless of whether the event is heard. Thus, synchronization of audio, video, and haptic data becomes very crucial. This might, incidentally, be achieved by receiver buffering, thereby removing entirely the challenge for the communication network in achieving the required latency (e.g., jitter).

To meet stringent end-to-end (E2E) QoS requirements, the architectures should also provide advanced operation and management functionalities such as lightweight signalling protocols, distributed computing and caching with predictive analytics, intelligent adaptation with load and network conditions, and integration with external application service providers (ASPs).

As a result, reliability, latency, and scalability can be considered as key performance indicators (KPIs), where omnipresence (rapid "latching" of TDs to TI infrastructure), ad-hoc (minimal upkeep of Tl network domain), and hybrid (scalable yet minimalistic upkeep of a TI rendezvouz device) can be considered three main approaches for bootstrapping a TI service and instantiating the architecture. The TI design is inherently built on the notion of edge-mandated operational settings and core-managed E2E sustenance. That is, the TD at the edge would state its communication and operational parameters (e.g., expected latency and reliability) and communicate that to the TI architecture, which will then engage the required resources to meet such requirements, both in bootstrapping setup and E2E communication.

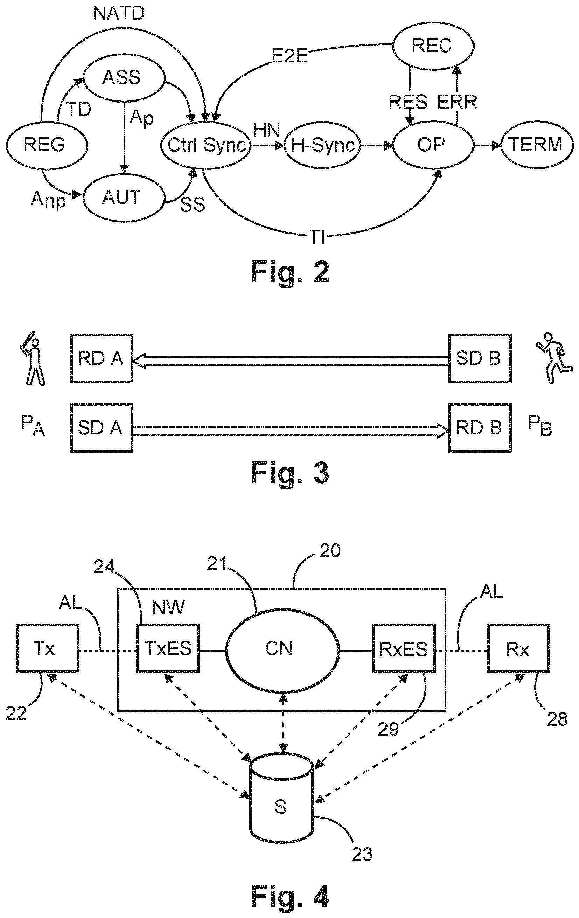

Fig. 2 schematically shows a state diagram representing operational states of an overall operation finite state machine for implementing a metaverse application.

A TD device may start with a registration phase (REG), which is defined as the act of establishing communication with the TI architecture. Under the omnipresent TI paradigm, registration will take place with a GNC, potentially including TI components from the ND, such as the TSM. A selected application can provide a user interface for a user/ROI to register, e.g., in the TSM. The registration may be achieved through the application itself, or through the TSM, and may include registering the TDs that the user/ROI has. It may involve registering a TD as part of the communication infrastructure, e.g., as part of the 5G system (5GS) to have access to functionalities offered by the 5GS such as quality of service (QoS), low latency, edge computing, or synchronization of communication flows.

During registration, the TSM may allocate a TE to the user and/or ROI and/or TDs that is/are close or that is suitable for its communication parameters. In some cases, a sensor TD may generate output that is fed to rendering TDs in the same ROI.

The "latching" point of the TD to initiate registration may be referred to as TI anchor. At this stage, the TD may be probing the TI architecture to invoke E2E communication and may not perform any other functions beyond latching onto the TI architecture. In both the ad hoc and the hybrid models, this step may involve the TSM, potentially via the GNC in the former, to establish registration.

The next state depends on the type of the TD. If it is a lower-end SN/AN, then the TD may have a designated "parent" in its close proximity, with which the TD may need to associate (ASS) first. This parent TI node may thereafter ensure reliable operation and assist in connection establishment and error recovery. If a TD device operates independently, then this would be an optional step. Some mission-critical TDs, as well as new ones, may need to be authenticated (AUT) without parent (Ap) prior to being allowed to join/start a TI session (SS).

Another phase may be an optional state in which a TD (NATD) may communicate with an authenticating agent in the TI infrastructure to carry out authentication. The TSM may be an entity that could carry out this task, perhaps with assistance from the SE when needed, or with significant amounts of traffic. The TD may then commence its E2E control synchronization (Ctrl Sync), where it may probe and establish a link to the end TE. At this state, the TD may not be allowed to communicate operational data, yet may focus on relaying connection setup and maintenance parameters. This may include setting the parameters for interfaces along the E2E path, which may aid the ND in selecting an optimal path throughout the network to deliver the requested connection parameters. This state encompasses the path establishment and route selection phases of TI operation. It may typically involve multiple tiers of the TI architecture, which may communicate to ensure that a path that meets the minimum requirements set in the "setup" message is indeed available and reserved.

If the TD engaging in a Tl session is a haptic node (HN) targeting haptic communication, then the next state may encompass the specific communication and establishment of haptic-specific information, still before actual data communication. This state involves deciding on codecs, session parameters, and messaging formats specific to this current TI session. While different use cases may mandate different haptic exchange frequencies, it is expected that every haptic communication will start with a haptic synchronization state (H-Sync) to establish initial parameters. Future changes to codecs and other haptic parameters may then be handled as data communication in the "operation" state (OP). This ensures that all haptic communication will enforce an initial setup, regardless of future updates to the parameters which may be included in operational data payloads.

All TD components may then transition to the operational state. At this state, the E2E path has been established, all connection setup requirements have been met, and the TEs are ready to exchange TI information. During operation in this state, one TD may detect an intermittent network error (ERR), in which case the TD may transition into a "recovery" mode (REC), in which designated protocols may take over error checking and potential correction mechanisms to attempt to re-establish reliable communication. If the error proves to be intermittent and is resolved, then the TD may transition back to the operational state. If for any reason the error perseveres, then the TD may transition back to control synchronization and rediscover whether or not an E2E path is indeed available under the operational requirements set out by the edge user.

Finally, once the TI operation is successfully completed, the TD may transition to "termination" phase (TERM), in which all the resources that were previously dedicated to this TD may be released back to the TI management plane. If that was initially handled by the NC, then the resources return to it. Most typically, the TSM may be involved in the provisioning of TI resources.

Fig. 3 schematically shows an exemplary metaverse scenario where two persons P_{A} and P_{B} are willing to interact in the metaverse. To this end, the two persons have corresponding rendering devices RD A and RD B, e.g., a virtual reality (VR) device and corresponding sensor devices SD A and SD B. The two persons P_{A} and P_{B} are separated by a distance d. Since a high-quality data representation is required, the sensor devices SD A and SD B need to sample a high-quality representation of a person that is to be transmitted to the rendering device of the other person. Therefore, high-quality communication with reduced communication overhead is desired.

In the following, embodiments for enabling high-quality communication or interaction with low communication overhead achieved by compression are presented.

Fig. 4 schematically shows a block diagram of a network architecture for implementing some of the embodiments.

A transmitter (Tx) 22 is understood to be a device that senses or generates data to be compressed (e.g., a 5G UE). Data or compressed data is transferred to a network (NW) 20 via an access link (AL), e.g., a 5G New Radio (NR) radio link. Furthermore, a receiver (Rx) 28 (e.g., a 5G UE) is understood to be a device that renders data or compressed data. Data or compressed data is transferred from the network 20 via an access link (AL), e.g., a 5G NR radio link.

Furthermore, a network (NW) 20 is provided, which is understood to be any type of arrangement or entity that is used to transfer, store, process and/or otherwise handle data or compressed data. The network 20 may comprise multiple logical components distributed over multiple physical devices. In embodiments, network edge servers 24, 29 and a core network (CN) 21 may be provided.

The network edge servers 24, 29 are understood to be devices that are physically close to a radio access network (not shown) and which provide data processing and storage services for a user device (e.g., UE) involved in an interaction or communication. The physical proximity provides for very low latency communications with the user device. In an exemplary application, a transmitting edge server (TxES) 24 and a receiving edge server (RxES) 29 may be provided at the transmitter 22 and the receiver 28, respectively, and may be configured to provide storage capability for data and a compression/decompression database, compression/decompression functions and a negotiation function for negotiating with peer devices.

Furthermore, the core network 21 is understood to comprise remaining parts of the network 20 used to transfer data between the transmitter 22 and the receiver 28, possibly via the respective edge servers 24, 29.

Additionally, a shared storage (S) 23 may be provided as a virtual device that represents memory shared by both the transmitter 22 and the receiver 28 and/or the compression and decompression functions of the edge servers 24, 29. It can be physically located in one or more places with multiple copies being synchronized as necessary.

The communication parameters are understood to be parameters affecting the performance of the communication or posing requirements on the communication. They may include at least one of latency, QoS, distance between communicating parties, computational requirements to process the communication, computational capabilities to process the communication, memory requirements to process the communication, memory capabilities to process the communication, available bitrate, number of communicating parties, and the like. Some of these parameters are related to each other. For instance, the latency between two user devices depends on the distance between the devices, but also on other aspects such as the computational requirements and/or capabilities to process the communication, in particular, if the communication involves a predictive model, the communication latency may be influenced by the available/required computational capabilities of both devices.

In some embodiments, only some of the above communication parameters may be mentioned without loss of generality. For instance, if an embodiment only mentions the latency, this should be understood as latency or other communication parameters, in particular, other communication parameters influencing the latency of a communication link.

In embodiments, sufficient image quality can be provided at the receiving end (e.g., a realistic representation of a person) by using data compression. Such data compression my involve conventional data compression schemes. Additionally, specific data compression schemes and corresponding devices or systems for compressing and decompressing data are described in the following embodiments. It is to be noted that these embodiments, while being beneficial for specific applications mentioned herein, could also be implemented independently, e.g., in other context than metaverse and for other applications.

Embodiments may relate to a first type of system where a compressing device aims at taking some input data and storing it efficiently in a storage unit. This may be useful in a cloud-based setting in which some data needs to be efficiently stored. Here, a compressing device or encoder is used as a device (which may be a software product) that performs data compression. For instance, the device may receive data and may be capable of breaking down (classifying) the data into one or more data objects according to appropriate criteria and then compressing data objects again according to appropriate criteria, storing the compressed data objects together with any necessary compression model and other metadata required to enable later reconstruction of the source data. Appropriate criteria may include consideration of required (semantic) accuracy of reconstruction, available storage space and processing resources for reconstruction and so on. For the purposes of this disclosure, criteria may also include consideration of the semantic content of the data and data objects and compression model(s) to be used.

Optionally, a decompressing device (or decoder) may be provided, which is understood as being a device (which may be a software product) that retrieves compressed data from storage and, using the appropriate (de)compression models, reconstructs and renders the original data with minimal semantic loss. To this end, a compression model repository may be used, which is understood as being a database that comprises tools and data objects to be used for data compression and that, advantageously, is available for both compressing device and decompressing device. A subset of the tools and/or data objects of the repository may be combined to form a compression model that is optimized in some way for a given sample or type of data.

The storage unit is understood as being a device accessible by the compressing device when storing and the decompressing device when retrieving, that stores compressed data and (an) accompanying compression model(s) and metadata. It may also hold the compression model repository. The storage unit may take many forms. It may be a web-based server, for example, or it may be a physical device, such as a memory stick, hard drive or optical disc.

Other embodiments may relate to a second type of system in which a compression/transmitting device aims at exchanging data in an efficient manner with a second decompressing/receiving device. This may be useful in a setting in which a transmitting device (e.g., a streaming service cloud) wants to efficiently share data with a receiving device (e.g., a TV). In some cases, the transmitting device (e.g., the transmitter 22 in Fig. 4) may have sensors capable of sensing/capturing data, e.g., a VR glass or a mobile terminal or user equipment. In some cases, the receiving device (e.g., the receiver 28 of Fig. 4) may have sensors capable of reproducing/rendering data, e.g., a VR glass or a mobile terminal or user equipment. In some cases, an edge server (e.g., edge servers 24, 29 in Fig. 4) may be associated to one of the transmitting/receiving devices taking over and/or sharing some of the functionalities. In some cases, some of the transmitting/receiving devices may be part of a telecommunication system such as the 5G system. In connection with the other embodiments of the second type of system, a compression transmitting device is understood as being a compressing device that compresses data substantially in a streaming manner, typically taking into account latency or computational overhead or communication overhead at either the transmitting/receiving devices as part of its compression criteria, and which delivers compressed data to a transmission channel. Furthermore, a decompression receiving device is understood as being a decompressing device that decompresses data as it arrives on a transmission channel, typically rendering it in real-time and typically taking into account latency or computational overhead or communication overhead as part of its rendering criteria.

An (optional) edge server may be provided next to the compression transmitting device and may be capable of assisting the compression transmitting device by compression (post-)processing, supplying or updating compression models on-the-fly, or otherwise ensuring timely delivery of compressed data. Similarly, an (optional) edge server may be provided next to the decompression receiving device and may be capable of assisting the decompression receiving device by decompression (pre-)processing, supplying or updating compression models on-the-fly or otherwise ensuring timely rendering of decompressed data.

Moreover, (optional) sensors (e.g., audio, video) may be provided at the compression transmitting device and may be configured as a device or an array of devices that captures some aspect of a scene, typically, but not necessarily in real time. Examples include a camera, a microphone, a motion sensor and so on. Some devices may capture stimuli outside human sensory range (e.g., infra-red camera, ultrasonic microphone) and may 'downconvert' them to a human-sensible form. Some devices may comprise an array of sensor elements that provide an extended or more detailed impression of the environment (for example, multiple cameras capturing a 360° viewpoint, multiple microphones capturing a stereo or surround-sound sound field). Sensors with different modalities may be used together (e.g., sound and video). In such cases, different data streams need to be synchronized. The compression transmitting device equipped with sensors may be VR/AR glasses or simply a UE.

In addition, an (optional) rendering device (e.g., audio, video) may be provided at the decompression receiving device and may be a device or an array of devices that renders some aspect of a scene, typically in real time. Examples include a video display or projector, headphones, a loudspeaker, a haptic transducer and so on. Some rendering devices may comprise an array of rendering elements that provide an extended or more detailed impression of a captured scene (for example, multiple video monitors, a loudspeaker array for rendering stereo or surround-sound audio). Rendering devices with different modalities may be used together (e.g., sound and video). In these cases, a rendering subsystem must ensure that all stimuli channels are rendered in synchrony.

Furthermore, a (optional) communication manager may be provided in the system of the second type, which may be an entity, either centralized or distributed, that manages communications. A goal of the communication manager may be to optimize the communication in terms of latency, overhead, etc. The communication manager may be an entity in a communication network such as the 5GS or may be an external entity such as an application function.

As a further (optional) element of the system of the second type, a compression model repository may contain information such as data, machine learning (ML) models used to derive data, etc., useful to reconstruct data based on, e.g., prompts.

In the following embodiments (of which at least some may be combined for further improvement of performance) compression and reconstruction of data may be based on prompts for text-to-image models (such as latent diffusion models), which can be learned on-the-fly to represent previously unseen objects without needing to retrain the entire reconstruction model. This technique ("textual inversion") can be done quickly and iteratively, as described in Rinon Gal et al.: "An Image is Worth One Word: Personalizing Text-to-Image Generation using Textual Inversion" (retrievable at: https://textual-inversion.github.io/).

Furthermore, in embodiments, compression and reconstruction of data may be based on a system in which generative compression, based on textual inversion, is guided by an input image so that the reconstruction remains similar to that image, as described in Zhihong Pan et al.: "EXTREME GENERATIVE IMAGE COMPRESSION BYLEARNING TEXT EMBEDDING FROM DIFFUSION MODELS" (retrievable at: https://arxiv.org/pdf/2211.07793.pdf).

Additionally, in embodiments, image classification may run rapidly on low-capability devices as described in Salma Abdel Magid et al.: "Image Classification on loT Edge Devices: Profiling and Modeling" (retrievable at: https://arxiv.org/pdf/1902.11119.pdf).

Typically, diffusion models are good at reproducing items which formed part of their training data set, but bad at reproducing those which did not. Since the training datasets may be taken from the public internet and diffusion models are costly to retrain, this leads to a problem with reproducing a-priori unknown inputs.

For example, a diffusion model may be able to recreate an image of a generic person from a prompt such as "a young man", but could not recreate an image of any one, specific person (except in some edge cases such as celebrities).

This loss in realism between the regenerated output and the original observations is referred to as "semantic loss" and differs from the distortion introduced by traditional codecs in several ways; notably, by being much more dependent on the original objects being observed.

In addition to semantic Loss, spatial and temporal stability can be a problem. In a related technique (Neural Radiance Fields or NERFs), recent work has addressed techniques for improving spatial and temporal stability.

Recent techniques (e.g., as introduced above) have tried to address the problem of semantic loss. The state of the art in this area is represented by textual inversion, i.e., dynamically learning embeddings representing previously unseen objects, without having to re-train the overall diffusion model. Thus, guide images are used to ensure that learned embeddings adequately represent the observed reality (as represented by the guide image).

In the following embodiments, such learned embeddings are referred to as "learned prompts".

Furthermore, inpainting is a process of replacing one object with another in the reconstructions generated by diffusion models. A recent technique demonstrated exemplarguided image editing, in which a given image (the exemplar) can be in-painted into an existing reconstruction without causing fusing artifacts.

Separately from the above, instance segmentation is a machine learning workload. For example, image segmentation can be used to identify and classify each object in an image. Such techniques can run rapidly on moderate hardware.

Additionally, the saliency of objects in an image can be calculated and may also account for the semantics of objects in the image. Saliency refers to unique features (e.g., pixels, resolution etc.) of an image in the context of visual processing. These unique features depict the visually alluring locations in an image. A saliency map is a topographical representation of them. Saliency typically arises from contrasts between items and their neighborhood. They may be represented, for example, by a red dot surrounded by white dots, or by a flickering message indicator of an answering machine, or a loud noise in an otherwise quiet environment.

According to embodiments, devices such as UEs use generative compression based on the device's local generation of inputs to a shared reconstruction model ("learned prompts") and their comparison to a segmented, observed scene on an instance-by-instance basis, to achieve a controllable degree of semantic loss within bandwidth, computation and latency targets (which may be negotiated with a network function).

A transmitting device may observe a scene using sensing of some kind (which can include audio, video, image capture, etc.) and may then segment its observation to produce instances relating to identified semantic objects. It may then classify these objects according to ease of reconstruction by the shared reconstruction model and may so derive portions of the input which are likely to be reconstructed well (i.e., because they are well-represented in the training data set), and others which are not. For those parts of the scene which can be well-reconstructed, the transmitting device may directly generate a suitable learned prompt.

For parts of a given scene which cannot be easily reconstructed by a shared reconstruction model, the transmitting device may take at least one of several paths, for example (i) transmit its best guess learned prompt; (ii) use a more advanced and demanding technique (such as guide images), or; (iii) simply revert to transmitting 'physical' inputs (i.e., non-prompt compressed data which has been compressed using conventional techniques), e.g., in decreasing order of semantic loss. The receiving device may then use inpainting (or a similar technique) to stitch together the reconstructed scene from a combination of reconstructed learned prompts and any physical inputs. Additional consistency data generated by the transmitting device may help to retain spatial, temporal, and other forms of consistency in the reconstruction. Moreover, the reconstruction may serve as a predictor for at least part of the image, and a conventional video encoder may be used to compress the residual image whereby rate-distortion optimization may be guided by a saliency map, allocating more bits to salient areas (e.g., a face) while leaving realistic but inaccurate data in non-salient image regions (e.g., a backdrop). Furthermore, the reconstruction may serve as one of the reference frames that is used by a conventional video encoder to encode the frame, again potentially with the help of a saliency map to guide rate-distortion optimization.

Hence, a system for generative compression based on learned prompts is proposed, in which a segmentation is performed by classifying inputs according to their likely 'ease' of reconstruction by an applied reconstruction model prior to transmission, thus deriving an estimated semantic loss. This may be carried out for a plurality of semantic regions and/or features in an input, deriving an estimated semantic loss per region (e.g., by instance segmentation in an image). The 'ease of reconstruction' calculation may be updated dynamically during an interaction to account for new learned prompts available to both transmitting and receiving device.

Additionally, a semantic loss negotiation may be applied by having the transmitting device (encoder) decide which input parts to encode/transmit using its prompts, and which to encode/transmit conventionally (or otherwise), based on a negotiation with an external party (e.g., a network function). The negotiation may be two-way (i.e., the transmitting device may request a necessary bandwidth to achieve an acceptable semantic loss and may feed back requests based on its observed scene, since this trade-off may vary dynamically).

Based on a given rate-distortion formula: *L*(*k;* **p**) = *kR*(***p***) + *D*(***p***) where *R*(**p**) is the bitrate for a give set of parameters p, D is the distortion as measured by comparing the reconstructed signal with the uncompressed reference and *k* controls the importance of bitrate versus quality, a loss function *L*(*k*; **p**) may be minimized.

The negotiation maybe one-way if it is based on, e.g., a configured policy.

Finally, learned prompts may be compared to reality before transmission. The reality may be observed prior to transmission of prompts to allow selection. The comparison may instead or additionally be to a predicted version of reality, with optional corrections being transmitted for any pre-computed prompts after the true reality is observed.

Spatial or temporal stability can be achieved by generating additional data at the transmitting device with its knowledge of the reconstruction model and its observation of the scene, to enhance the spatial or temporal consistency of the reconstruction.

The contribution of diffusion versus conventional video codec to the overall video coding bitrate and quality may be gradually altered to hide a strategy switch such as a changing prompt by changing parameters smoothly. For instance, given saliency or rate allocation maps of two intra frames, the maps of enclosed inter frames, may be interpolated and these maps may then guide the conventional video codec.

Additionally, reference frames (as output by the decoder) may be downscaled and input to a diffusion model together with the prompts, to constrain the output of the diffusion model for a dependent frame. With a hierarchical group-of-pictures (GOP) structure this process may be repeated for each temporal layer.

As mentioned earlier in connection with the first type of system, rather than transmitting the compressed data to a receiving device, in a further option, the compressed data may instead be stored in a database local to the transmitting device.

In the following, the above options of the proposed compression scheme are described in more detail based on various embodiments.

In a first embodiment, a transmitting device (e.g., an UE device) uses (generative) compression for some input data (e.g., audio, images, video,...), based on a device's local generation of inputs to a shared reconstruction model and their partial comparison to some input data (e.g., an observed scene), to achieve a controllable degree of semantic loss within bandwidth, computation and latency targets, which may be negotiated with a communication manager (e.g., a network function in the 5G system).

The transmitting device first classifies the data (e.g., an observed scene), and using its knowledge of the shared reconstruction model, derives portions which are likely to be reconstructed well (i.e., because they are well-represented in the training data set), and others which are not. Since data (e.g., image) classification can run quickly even on low-grade hardware, this initial data map can be quite quick to produce. For those parts of the data which can be well-reconstructed, the device can generate a suitable prompt, e.g., using a textual inversion technique, e.g., as described in Rinon Gal et al.: "An Image is Worth One Word: Personalizing Text-to-Image Generation using Textual Inversion*".*

For those parts of the data which cannot be easily reconstructed, the transmitting device may (i) transmit its best guess prompt and/or (ii) use a more advanced and demanding technique (such as that of Zhihong Pan et al.: "EXTREME GENERATIVE IMAGE COMPRESSION BY LEARNING TEXT EMBEDDING FROM DIFFUSION MODELS*"*)*,* and/or (iii) simply revert to transmitting 'physical' data (i.e., that are compressed using conventional compression techniques) e.g. in decreasing order of semantic loss.

By such simple partitioning of the scene, the semantic loss may therefore be controlled in an end-to-end manner alongside bandwidth and computational demand.

In a second embodiment (directed to a negotiation between the network and the user device (e.g., UE)), an amount of acceptable semantic loss may be jointly set between the transmitting device with an input data (e.g., a view of a real scene), and a communication manager (e.g., a 5G network function) which tries to optimise throughput, latency, or overhead. The transmitting device may try to maximise the similarity of the reconstructed data set to reality, while the communication manager may enforce a higher degree of compression, tolerating semantic loss in return for lower latency and bandwidth. This may lead to a negotiation of, e.g., the compression parameters that may then applied by the user device.

In a third embodiment (directed to a co-learning of new prompts and their semantic loss), as a communication or interaction by the transmitting or receiving device continues, a compression/reconstruction model shared between two users (or the transmitting/receiving devices associated to them) is dynamically updated and/or extended to previously unseen entities by transmission of feedback as to how well the newly-generated prompts matched the observed scene. This score may then be fed, e.g., into the initial data object classification (e.g., image segmentation) process at both ends. The model may also be extended by keeping track at the transmitter of seen entities, and when an unseen entity is detected, then the newly generated prompt for that unseen entity and the unseen entity are added to the local model of the transmitting device and sent to the receiving device so that the model of the receiving device is enhanced as well.

In a fourth embodiment (directed to predictive operation), the processes of the above or other embodiments may run predictively. For example, the transmitting device may generate prompts predictively based on locally predicted motion within the scene or based on communication parameters (e.g., delay) with a receiving device. It may pre-transmit these, and then when a true change in the scene is observed, simply transmit a short command as to which prompt to use, e.g., plus a small correction factor (as described e.g. in Zhihong Pan et al.: "EXTREME GENERATIVE IMAGE COMPRESSION BY LEARNING TEXT EMBEDDING FROM DIFFUSION MODELS*"*) to correct for differences between the observed scene and the predicted one. This could allow for near-zero added latency even for very high bandwidth content.

In a fifth embodiment related to a use of the proposed compression scheme in a telecommunications network (e.g., 5G network), two users may use devices (e.g., UEs) connected to edge servers to engage in telepresence where virtual reality technology is used e.g. for remote control of machinery or for apparent participation in distant events. Here, the edge servers can be used to optimize bandwidth and latency over the 5G network.ln a specific example, a transmitting UE may be configured to observe a scene with its cameras and forwards the data to a transmitting edge server which classifies the data into data objects of high or low likelihood of reconstruction, and, according to desired 'bitrate' feedback from the network, generates and transmits model prompts for easy-to-reconstruct data objects up to a threshold for a shared, generative reconstruction model running on a receiving edge server. For hard-to-reconstruct data objects, the transmitting edge server may further arbitrate between bandwidth, computational requirements, and semantic loss according to network feedback. The transmitting edge server sends the compressed data to the receiving edge server and the receiving edge server reconstructs the data from the prompts and forwards the reconstructed data to its UE. Furthermore, the transmitting edge server, with UE input, may optionally run the above system predictively, as described in connection with the above third embodiment.

In a sixth embodiment related to multimedia data, the prompts may be linked to metadata that may include multiple parameters e.g., as described below in variants of the sixth embodiments. The metadata may serve to facilitate reconstruction of compressed data, in particular, when the data relates to, e.g., multimedia data or video.

In a first variant of the sixth embodiment, a prompt can be linked to a temporal range (e.g., to enable video or audio) so that a single prompt needs to be transmitted for a given period of time. To this end, the prompt can be linked to metadata including parameters such as an estimated decay time (e.g., number of frames in video) over which it is expected or known to be valid. The prompt could optionally be used past this decay time but at the cost of increasing semantic loss.

In a second variant of the sixth embodiment, a moving image could be linked to an initial prompt, an end prompt, a temporal range, and a moving pattern. The receiver may then be configured to use the reconstruction model to reconstruct movement from the prompt and metadata

In a third variant of the sixth embodiment, prompts or compressed data related to different data types (e.g., audio and video) may need to be synchronized. For instance, a video prompt may include metadata with a "link" to its audio prompt. This third variant may be of particular interest if audio and video are both subject to generative compression where prompts need to be linked. Various ways to do this may include matched 'decay times' for the audio and video prompts (as above) and/or a trained reconstruction model which reconstructs both audio and video from a shared latent space, and design prompts for that latent space and/or use of generative compression for the video only, wherein the audio uses something else (in which case the audio could just be linked in time to the video frames). For instance, compressed data of different data types may be linked to metadata determining the time frame the data is rendered. For instance, if the image in a video relates to prompt "Alice waking in the street" with metadata "Time: [0.00", 5.00"]" the audio in a video relates to prompt "Alice says: "Hi darling"" with metadata "Time: [2.00"-3.50"]", then synchronization requires to play the audio related to the audio prompt with a duration of 1.50 starting in second 2. The fact that the audio prompt indicates that Alice speaks, this also influences the video rendering requiring that Alice is rendered so as to speak "Hi darling" between second 2 and second 3.50.

In a fourth variant of the sixth embodiment (relevant, e.g., for audio and/or video prompts), the prompt metadata may include parameters to determine how the reconstructed data, e.g., audio, is mixed. For instance, which voice is louder when two persons talk simultaneously, or which one is in front of the other one when two persons walk close by. In general, this may be a relevant feature of any generative audio/image/video compression algorithm that uses textual inversion. The learned prompts may need to take overlapping data objects, e.g., overlapping voices, into account. In some cases, it may be more efficient to have more than one learned prompt in such a case (e.g., voice A, voice B, and degree of overlap).

In a fifth variant of the sixth embodiment variant, e.g., for a metaverse scenario, the image of a person may be linked to a prompt linked to an existing avatar. For instance, a picture of a user may be linked to a prompt "S" which is linked to an avatar Y. An avatar is a digital representation of a user (participant) and this digital representation may be exchanged (with other media, e.g., audio), with one or more users as mobile metaverse media.

In an example of the fifth variant, an avatar call may be established, which is similar to a video call in that both are visual, interactive, provide live feedback to participants regarding their emotions, attentiveness and other social information. Once the avatar call is established, the communicating parties may provide information in uplink direction to the network. A terminal device (e.g., UE) may capture facial information of the call participants and may locally determine an encoding that captures the facial information (e.g., consisting of data points, colouring and other metadata). This encoded information may be transmitted as a form of media uplink and provided by an IP multimedia subsystem (IMS) to the other participant(s) in the avatar call. When the media is received by a terminal device (e.g. UE) of the participant, the media is rendered as a two (or three) dimensional digital representation.

In this use case, the terminal device performs processing of the data acquired by the terminal device to generate an avatar codec. It is possible to send the acquired data (e.g., video data from more than one camera) uplink so that the avatar codec could be rendered by the 5G network. It may however be advantageous from a service perspective to support this capability at the terminal device. First, the uplink data requirement can be greatly reduced. Second, confidentiality of the captured data could prevent a user from being willing to expose it to the network. Third, the avatar may not be based on sensor data at all, if it is a 'software-generated' avatar (as by a game or other application, etc.) and in this case there is no sensor data to send uplink to be rendered.

If a participant of the avatar call cannot be captured due to a lack of sufficient camera support at the terminal device, the participant may instead use a text-based avatar media. This media allows the participant to express what he/she wants his/her avatar to say, and can include (through standardized conventions) speech pauses (e.g., "..." results in a pause), emphasis (e.g., "*SORRY I AM GETTING LOUD, BUT I HAVE TO SPEAK MY MIND*" results in louder speech and more emphatic gestures), and emotions (e.g., ":)" results in the avatar smiling). The text-based avatar media may be transported to the point at which this media is rendered as a 3D avatar media codec. The rendering of the text-based avatar media to 3D avatar media could be at any point in the system. The caller's terminal device, the network or the callee's terminal device. The callee's terminal device is able to display an avatar version of the caller and hear it speak (e.g., text to voice.) To the extent that the avatar configuration and voice generation configuration is well associated with the caller, the callee can hear and see him/her speaking, though the caller only provides text as input to the conversation.

To implement the fifth variant, the network (e.g., 5G system) may support a means for terminal devices (e.g., UEs) to produce 3D avatar media information for the uplink direction and to receive such avatar media information from the downlink direction, where this avatar media information transmission requires a significantly lower data transfer rate than video.

Furthermore, the network (e.g., 5G system) may support a means for production of 3D avatar media information to be accomplished on a terminal device (e.g., UE) to support confidentiality of the data used to produce the 3D avatar (e.g., from the cameras of the terminal device, etc.).

The network (e.g., 5G system) may further be configured to support a means to provide service continuity for parties of an IMS video call, where the communication performance of one or more parties declines to the extent that video is no longer of sufficient quality or even no longer possible. In this case, an avatar call between the same parties can be used as a fall-back to replace the video call. Subsequently, when the communication performance improves to the extent that a video call is again possible, a video call may replace the avatar call.

Additionally, the network (e.g., 5G system) may be configured to support a means to transfer and process user-supplied standardized text-based avatar media as 3D avatar media, such that this text-based encoding includes standardized expressions indicating emphasis, speech pauses and emotions.

In a sixth variant of the sixth embodiment, compression techniques may be applied to audio information. For instance, if in a (metaverse/movie) scenario with two persons from France and Spain talking in English in New York City in the middle of traffic when someone screams and the dialog is about, e.g., politics. Then, semantics that can be exchanged may be heavy traffic, woman scream, English language, person 1: Spanish accent/male, person 2: French accent/female, person 1 says: "Mister X is my favourite politician"; person 2 replies angry: "Are you crazy? I cannot be with you anymore!". These semantics can also be passed to a predictive model to generate the audio/speech. In particular, the meaning of: "Mister X is my favourite politician" may be expanded to a 1min-long monologue in which the person explains why Mister X is the favourite politician giving reasons for this opinion.

In a related variant, the audio prompt itself may therefore indicate the meaning of the message and the duration of the speech but the content may be locally generated and/or generated by means of other means, e.g., a language model such as a generative pre-trained transformer (GPT) family (https://en.wikipedia.org/wiki/Generative pre-trained transformer) of language models such as ChatGPT. The generated text may then be text-voice transformed and fit in the required time interval.

In a seventh embodiment related to negotiation between a local (user) device (e.g., UE) and a network with split rendering, the local device may talk to a local edge server that communicates with a remote edge server to which the remote device is connected. In such a case, the functionalities may be split between local device and edge servers. For instance, the local device may send initial data (e.g., a whole image) to the local edge server that may compute prompts based on a "full" shared reconstruction model. The prompts and objects and a partial "reconstruction model" may then be fed back to the local device so that the local device can generate prompts associated to the object based on the "partial" (more lightweight) reconstruction model. In some cases, there may be a single edge server.

In general, the generation and reconstruction may be split between the local device and local edge server (conceptually similar to split rendering). In some cases, some existing mechanisms to enable split rendering may be useful to decide where to run which parts of the reconstruction model out of, e.g., device, edge server, cloud.

In a related embodiment, the edge servers can be used to take over some of the computational load of the UEs, e.g., in the context of split rendering. For instance, the UEs may be capable of performing locally certain tasks with low computational load such as the rendering of the image background while objects requiring no sematic data loss and a higher computation load may be rendered in the edge servers. In this embodiment, the transmitting edge server (UE) may indicate which data objects are preferred to be reconstructed where or it may indicate the required reconstruction capabilities so that the receiving edge server (UE) may decide which entity does what, i.e., split decoding/decompressing/rendering capabilities, e.g., based on a local policy.

In an eighth embodiment, a shared reconstruction model may be learned during interaction. For instance, the first time that a transmitting device (or encoder) observes an image and derives a prompt, the transmitting device transmits both prompt and image (e.g., using a traditional compression techniques). The image is then added to a local and remote reconstruction model.

In general, an "effective overall model" can be learned during the interaction. The "effective overall model" is understood as meaning a pre-trained diffusion model (which may stay static) plus any dynamically learned prompts derived during the interaction. The transmitting device may learn a prompt and transmit an image of the relevant object. The system can then update the "effective overall model" dynamically during use, by accounting for the new shared prompt and image which exists at both transmitting and receiving ends. In other words, the relevant object may become marked as "easy" to reconstruct even though the baseline diffusion model has not been changed. If, for example, a person in an image (i.e., an object in the data) turned sideways, the "dynamic" learned prompt for that person may no longer work, and so the transmitter may then need to derive a new learned prompt. This can be updated in turn. In some cases, it may be advantageous for both transmitting device (encoder) and receiving device (decoder) to store all these learned prompts and the effective overall model even after the communication is ended.

In a ninth embodiment related to receiver-side prediction, the receiving device (decoder) could compute a prediction (e.g., motion prediction) based on its already-received compressed data and generate prompts accordingly. It then shares its best-guess prompt(s) back to the transmitting device (encoder) which compares it to reality and transmits its selection of which prompt to use plus a small correction image if required.

In general, the decision on where to generate the motion prediction may depend on at least one of application, latency requirements, desired reconstruction fidelity and number of communicating parties. This may be configurable by means of a policy that may be deployed by a communication manager and which may be deployed to the transmitting device (encoder) or receiving device (decoder). This may also be configured/indicated in some metadata transmitted together with the compressed data.

In a tenth embodiment related to structed vocabulary for prompts and concerning generative models, the description language could be a structed language/vocabulary, a human-readable language, or pseudo-words, e.g., as described in Rinon Gal et al.: "An Image is Worth One Word: Personalizing Text-to-Image Generation using Textual Inversion*".*

In an eleventh embodiment related to the predictive nature of the proposed compression scheme, if both transmitting and receiving devices have the same generative models, then the receiving device may also generate the same prompts, meaning that the transmitting device only needs to select one of the common prompts and send a correction factor. In such an embodiment, the system could work either way, transmit prompt and then correction factor, or transmit instruction on which prompt to use, plus correction factor.

Once a prompt is generated, there may not be much difference in bandwidth requirement between just transmitting the prompt as it is or transmitting an instruction about which prompt to use (since the prompts may be just short text strings).

In a first variant of the eleventh embodiment, a suitable configuration may depend on how quickly the prompts could be generated from "instructions" at the receiving device, compared to the latency of transmitting an already generated prompt. This trade-off may be determined by the transmitting device and encoded in transmitted metadata or may be configured by means of a policy. The trade-off may depend on time, data object, etc.

In a second variant of the eleventh embodiment, there may be an advantage to have chosen a prompt at the receiving device before the (predicted) event occurs, and then receive a correction factor as soon as possible afterwards, since the receiving end may initially generate a (more lossy) output using the prompt, and then 'smooth' it into a desired output using the correction factor. In many cases, having at least some output with near-zero latency may be preferable.

In a twelfth embodiment, the proposed compression scheme may be applied to a 5G media streaming framework including concepts such as trusted media functions including aspects such as an adaptive bitrate encoder (cf. 3GPP specification TS 26.501). The transmitting device may access the trusted media functions e.g. via media control interfaces. In this scenario, a "semantic loss optimizer" may be defined as an additional trusted media function. Also, TS 26.117 defines speech and audio profiles for 5G media streaming, which may also be adapted accordingly. Similar to voice-over-LTE (VoLTE) bitrate negotiation mechanisms, the proposed compression scheme may imply a semantic-loss negotiation mechanism. Parts requiring adaptation and definition may include the negotiation between a transmitting device or edge server and a network function to optimize semantic loss for given bandwidth. Reasons may be that:
- the semantic loss is much more scene-dependent than a conventional compression loss algorithm, simply having the network provide a bandwidth target and letting the transmitting device (e.g., UE) compress video to reach that target may be sub-optimal. Sometimes, the transmitting device may be able to achieve high quality at very low bandwidth (e.g., a highly generic scene, such as a forest), while other times the same bandwidth may lead to near-total semantic loss.
- given a proposal for dynamically updating of the overall shared model during an interaction, it may be hard/impossible for the network function to predict the semantic loss accurately, justifying device feedback.
- a predicted latency or bandwidth target could be received from the network by a transmitting device or an edge server some time ahead.
- a shared reconstruction model structure could be standardized.
- a central database of already-learned prompts could be provided for download/pre-cache.

In a thirteenth embodiment, video codecs may be provided, that use a rate-distortion optimization algorithm for providing optimal reconstruction quality for a given a target bitrate or minimum bitrate for a given quality level. Rate-distortion optimization is used to improve video coding efficiency and aims at finding an optimal trade-off between reconstructed video quality and encoding rate. In traditional video coding standards, e.g. the emerging H.266/Versatile Video Coding (VVC), the H.265/High Efficiency Video Coding (HEVC) and H.264/Advanced Video Coding (AVC), sum of squared error (SSE) is used as a distortion criterion because SSE can represent the image fidelity efficiently. In connection with the proposed compression scheme, rate-distortion optimization may be achieved e.g. by generating a text prompt using textual inversion, running a text-to-image conversion based on the text prompt and calculating a color transform vectorthat modifies color for spatial region to better fit the true data. Additionally, or alternatively, the same could be done using texture transform (texture transform vector). In general, a transform for a given feature can be created and applied that modifies the area in the given region to better fit the data.

In a fourteenth embodiment, a shared reconstruction model may be used that derives portions of data where portions may refer to at least one of data objects, bounding boxes for classified regions, and masks resulting from instance segmentation. This reconstruction may be a policy determining how some portions of data need to be reconstructed in different situations/context.

In above embodiments, it is not clear how to deal with spatial borders between regions and appearing/disappearing objects overtime. For example, the position of an object is not well defined in most text-to-image diffusion models and the main subject is just placed at the center of the image.

Thus, in a fifteenth embodiment which may be combined with other embodiments or used independently, capabilities for spatially or temporary transition between prompt-based synthesis and traditional video codecs are included.

In a first example of the fifteenth embodiment, that may be combined with other examples, a video atlas may be used that groups the spatial regions that need to be coded using traditional video coding together in a single video atlas. These regions can result from instance segmentation. The renderer may first run a prompt-based synthesizer and after that, during a second pass, overplot the instance segmentation texture from the video atlas.

In a second example of the fifteenth embodiment, that may be combined with the other examples, (object) parts to be coded may be input using traditional video codecs as input to a denoising process. This may require training of a second diffusion model that synthesizes the image using text and partially defined image data as input.

In a third example of the fifteenth embodiment, that may be combined with the other examples, spatial consistency is another form of semantic loss which can be accepted or traded off against bandwidth and compute requirements.

In a fourth example of the fifteenth embodiment, that may be combined with the other examples, image-guided inpainting combined with instance segmentation may be used.

In other examples, similar capabilities may be applicable for the temporary transition between prompt-based synthesis and traditional video codecs. For instance, an object at a(n initial) time interval t0 may be synthesized by means of a traditional video codec (e.g., because the object is not part of the model at the receiving side yet). During this time interval, the model at the receiving side may be enhanced to include this object and associated prompt(s). In time interval t1, the same object may then be synthesized by means of a prompt-based approach. Thus, the synthesized objects between t0 and t1 need to be temporary transitioned, e.g., in a similar was as in above examples for spatial transition.

The above embodiments do not describe how to synthesize a frame when a video/image/sound consists of two or more objects that cannot be rendered from a single text prompt.

Thus, in a sixteenth embodiment which may be combined with other embodiments or used independently, a diffusion model for image (also other data types) synthesis may be trained from a partially masked image, where a masked area may be a region that corresponds to a portion predicted by a first text prompt whereas an unmasked region corresponds to a portion that is predicted by a second text prompt. The network can then be applied recursively during inference time to fill the entire image using multiple text prompts.

The above embodiments do not fully address how to deal exactly with video information.

Thus, in a seventeenth embodiment which may be combined with other embodiments or used independently, camera or independent object motion parameters may be included during training to provide information to the network on how to generate a time-consistent video.

What separates videos from images is that videos have a temporal structure in addition to the spatial structure found in images. As a video is just a collection of images operating in a specific temporal resolution, i.e., frames per second, information in a video is encoded not only spatially (i.e., in the objects or people in a video) but also sequentially and according to a specific order (e.g., catching a ball vs. throwing a ball, dancing salsa vs. hugging, etc.). This extra bit of information is what makes classifying videos quite interesting and yet challenging at the same time.

In a first variant of the seventeenth embodiment, a new generative prompt may be predicted for every frame at the cost of compute time. Techniques for generative compression technique may be applied, e.g., dealing with video by operating on keyframes and infilling. This could be made more robust under high relative motion conditions by increasing the number of keyframes (up to 100% as above) to reduce the infilling error.Similarly, techniques based on neural video compression may be used where the concept of optic flow may be used to train a "motion-aware" branch which is used to predict the error in an interpolation branch.

Optical flow is a powerful idea which has been used to significantly improve accuracy when classifying videos and at lower computational costs. It is a per pixel prediction based on an assumed brightness constancy, meaning it tries to estimate how pixels brightness moves across the screen over time. It assumes that the pixel characteristic at time t (e.g., RGB values) is the same as the pixel characteristics at a later time t+Δt but at a different location (denoted e.g. by Δx and Δy), where the change in location is what is predicted by the flow field. An example of this is that assume we have the following RGB values at t = 1s, (255, 255, 255) and at x, y position (e.g.,10, 10) in a frame, optical flow assumes that at t = 2s, the same RGB value (255, 255, 255) will still exist in the screen and if there is motion, it will exist at a different position of the frame (e.g., 15, 19). Thus, an optical flow displacement vector for this motion will be [9, 5]. This means if the original pixel position is taken and the displacement vector is applied, the new image can be predicted.

In a further related variant of the seventeenth embodiment, a generative prompt may be used to generate a (moving/static) object over a number of frames.

In an eighteenth embodiment extending the first embodiment, the reconstruction may serve as a predictor for at least a part of the data (e.g., an image) and a conventional data (e.g., image, video) encoder may be used to compress residual data (e.g., an image). This means that it is possible to perform enhanced video coding with a diffusion base layer and conventional enhancement layer. Additionally or alternatively, the reconstruction may serve as a reference frame used by a conventional video encoder to encode the frame.

In above embodiments, without mitigation, it may be visible when the codec switches strategy between diffusion-based neural coding and conventional video coding, due to largely differing trade-offs (e.g., where to put the bits).

Thus, in a nineteenth embodiment which may be combined with other embodiments or used independently,
- the contribution of diffusion to the overall video coding may be gradually altered (at some cost) to hide the strategy switch, and/or
- there may be a hybrid solution (e.g., as in the eighteenth embodiment) so that there may be some involvement of a conventional video codec to hide "diffusion weirdness", and/or
- 'smoothing' functions may be applied, e.g., by using 'smoothing' techniques for in-painted images and/or
- variants of, e.g., embodiment fifteenth may be applied.

In a twentieth embodiment, the (e.g., video) codec may be largely conventional and text labels plus diffusion may be used to improve an in-loop filter or post processing filter of an encoder and/or decoder. This means that the codec is defined and operates at object level. Thereby, temporary features such as, e.g., motion (in video) or voice tone changes (in audio) can be encoded with less bits because the codec operates at an object level instead of at pixel/block level. Text labels may be known (object database), or unknown, wherein the decoder may need to learn the object appearance on-the-fly. Note that "in-loop filter" implies that the encoder and decoder run the same filter, which in this context also implies the same learning steps for unknown labels.

In a twenty-first embodiment, there may be a side channel for object databases to efficiently transmit video of particular genres. To achieve this, decoders may fetch one or more databases when a video has corresponding labels. This may be done once or in a regular basis or on demand keeping a local copy. Alternatively or additionally, there may be a general object database that is part of a standard, where all decoders according to that standard recognize all these labels. Labels may have namespaces to indicate which database they belong to. A video may use multiple databases.

A twenty-second embodiment relates to a further class of embodiments (which may be combined with other embodiments or used independently) where multiple receiving devices receive compressed data presented by a transmitting device. The receiving devices may render the compressed data at different levels of quality according to their capability, link bandwidth, user requirements and so on. The transmitting device may generate, for example, multiple compression streams of varying levels of quality and/or sematic loss/compression, a single hierarchical stream from which a stream of a desired quality level may be extracted or a single high-quality stream, which can be further compressed, if necessary, by components in the network.

In a first example of the twenty-second embodiment, the transmitting device may generate multiple streams and may transfer them to a local edge server. Receiving devices that are allowed access to the streams may negotiate a quality level with their local edge server and the local edge server may negotiate with the transmitting edge server the delivery of a stream of the appropriate quality level.

In a second example of the twenty-second embodiment, the transmitting device may generate a hierarchical stream and may deliver it to its local edge server. The local edge server may extract streams of appropriate quality levels to deliver to the requesting receiving edge servers.

In a third example of the twenty-second embodiment, the transmitting device may generate a single high-quality stream, which may be uncompressed or compressed with conventional techniques, and may deliver it to its local edge server. The local edge server may perform image segmentation and compression according to the quality levels requested by the requesting receiving edge servers.

In a first variant of the above first to third examples, the transmitting edge server may deliver all data to the receiving edge servers, which may then derive compressed data streams as required by their receiving devices.

In a second variant of the above first to third examples, the transmitting edge server may collate feedback from the receiving devices and may optionally deliver it to the transmitting device.

In a further variant, the involved devices (e.g., a receiving device and receiving edge) perform a negotiation and/or signalling of the required data stream to use, e.g., based on the current network capacity (e.g., bandwidth), device capabilities/capacity (e.g., CPU), etc. For instance, if a receiving device has available CPU (the receiving edge may receive an indication from the receiving device) and the network is not saturated, then the receiving edge may decide to provide/transmit a data stream of higher quality (requiring more bandwidth / more CPU).

In a further variant, an involved device may explicitly/implicitly signal or determine the required data stream. For instance, a device may determine a preferred data stream based on the screen size of the receiving device.

In a twenty-third embodiment as a variant of the twenty-second embodiment that may be combined with other embodiments or used independently, data from the transmitting device may be recorded for later replay. The recording may comprise a single high-quality data stream, a hierarchically compressed data stream or one or more compressed streams of differing quality / sematic compression features. The recording may additionally comprise assistive data for compression purposes, for example, the compression/decompression database, relevant prompts and so on.

The recording may be stored in any of the transmitting device, a network device (e.g., the transmitter's local edge server or a receiver's local edge server) or a physical carrier (e.g., memory card, disc drive, optical disc, etc.).

Delivery of the recording to a requesting receiving device may take place in streaming fashion or the recording may be delivered as a single file or other data object. The receiving device may negotiate compression quality level in the same manner as previous embodiments.

This embodiment (and other embodiments) may be advantageous when applied to stream services such as video stream services or in a video conference service wherein the conference may be stored.

In a twenty-fourth embodiment, generative compression may be used for a two-way or multiway communication between a number of users. This may be particularly appropriate when screenshots of peer users are rendered as thumbnails during a presentation for example. In this configuration, a common compression/decompression database can be used to save resources.

As detailed earlier, the proposed data compression scheme may allow for high efficiency compression of various multimedia data.

Generative compression based on diffusion models offers potentially radical bandwidth savings. The process may be based on generating small inputs-typically short text strings - which can be used by a reconstruction model to recreate an approximate version of the original observed data. These inputs can then be stored in a database or transmitted over a network with a much smaller footprint than the original data, outperforming known compression codecs. This may relate to images and video, but may also extend to audio compression, or other data types.

In a further embodiment that may be combined with other embodiments or used independently, a user may have an application, e.g., an application running on a smart phone or computer capable of creating and editing content, e.g., audio visual material such as videos, e.g., by means of or supported by means of at least a generative model and an interpreted programming language. The user, who may become the content owner, may use prompts to create audio, video, images, etc. from the model composing a target content, e.g., audio visual material although it may contain other types of data/content. The user may then store the content and/or transmit the content to at least a (receiving) user/device.

In a further related embodiment, the generated content may be considered or called synthetic data that is specified by means of a "content program" that is taken as input by an interpreter of an "interpreted programing language" that relies on the generative model for the interpretation.

In a further related embodiment, since the generative model may provide the user with some options when the user tries a prompt, the user may choose one of the outputs of the model; since multiple generative models may be involve, the user may include the model identifier and/or version to ensure that the receiving party can regenerate the same content; since the generated audio/images/videos/etc. may not fully satisfy the user, the user may tweak (during the content creation process) the output and include changes with respect to the data. During the content creation process, the user may also take audio/video/... samples and assign them to a prompt so that the model is enhanced based on the user defined input. The user may create the content, e.g., a video, by using a programming language where a "content program" (or program) may be as in the following example:

| |
|---|
| [New video, Duration 12 seconds, Resolution xyx] |
| [Generative model ID xyz, version vxyz] |
| [Background image: part in spring, sunny weather] |
| [Background sound: happy piano music] |
| [Prompt: "small white cat"; Prompt_output: #3; Start time: 1 second; Duration: 10 seconds; Action: "walks from left to right"] |
| [Prompt: "big fat dog"; Prompt_output: #2; Start_time: 2 second; Duration: 9 seconds; action: "walks from right to left"; action: "smells cat and smiles"; action: "follows cat"] |

In this example of a "content program", a new command is given, e.g., in a new line between brackets. This means that a standard is required to determine what a new command is.

In this example, one or more (generative) model are indicated. It may be indicated by, e.g., means of a name or a URL. These generative models are then used by the interpreter to generate the content specified by the "content program".

In this example, there may be some keywords useful to determine which type of content is to be generated. Examples of those key words may be: "new", "video", "duration", "resolution", "Generative model", "Background image", "Background sound", "Prompt", "Prompt_output", "Start_time", "Duration", etc.

In this example, there may be a standard way of indicating which actions are associated to the keywords, e.g., the sequence [Keyword: Action;] may be used to indicate with "Keyword" that a new keyword is starting where the action associated to the keyword appears after ":" and ends with ";".

This information may be entered as text or by means of other type of user interface such as a graphical user interface.

The user may then play the generated video and further edit it until the user is satisfied with it. In this moment the user may release/publish it.

In order to verify the user who published the content, the data (or the hash of it) used to generate the (audio visual) content maybe signed by the user. A fingerprint may be made available (e.g., attached to the content or available in a public repository or blockchain) and the data may also be made available to allow other users to further create content based on it.

In a further embodiment, the program may be written by means of an interpreted programming language wherein the interpreter runs on, e.g., a computer, e.g., at the transmitter or receiver side and one or more (generative) models are used to generate the content by means of the interpreter.

In a further embodiment, the compressed data that may be obtained by an encoder may have a format as the "content program" wherein the compressed data may be featured by similar keywords / metadata to facilitate, e.g., the decompression/reconstruction of the data.

In a further embodiment, the compressed data may have compressed data fields for different data types (e.g., audio and video) wherein the keywords/metadata are used for the synchronization of the different data types during decompression/reconstruction.

In a further embodiment that may be combined with other embodiments or used independently, a transmitting user/enterprise/device may have an application to generate content, e.g., audio visual content. For instance, it may be audio visual content as in video streaming services such as NetFlix. The transmitting user/enterprise/device may then distribute the content to one or more receiving users/devices. In this embodiment, the model applied at the receiving side may be personalized. For instance, the transmitting user/enterprise may provide two or more (generative) models for the receiving users, e.g., a generative model A that generates content with certain features A (e.g., people are taller, people have an accent when talking, buildings have a given style) and a generative model B that generates content with certain features B. The receiving users may then select/use/be advised to use one of the models, e.g., either model A or B. This embodiment has the advantage that the receiving users can better select how the generated output looks like so that they will be more satisfied with the generated output and the service offered by the transmitting user/enterprise.

In a related embodiment, the transmitting user/enterprise/device may use the content generation application (as in above embodiments) to create/specify (slightly) different versions of the content by means of the content program such that the decompressed/reconstructed content/data fits the preferences of the receiving user/device. For instance, the content program may include the word "PREFERRED" to indicate to the receiving device that the background sounce should be generated by means of a local preference configuration, for instance, "PREFERRED piano music" may mean that the preferred piano music of the receiving device/user should be used. For instance, "Prompt: "small white cat"; Prompt_output: PREFERRED;" may indicate that the generated data when using as prompt "Small white cat" should be the one that may be preferred according to a local policy, e.g., the local preference policy of user A may say that cats with long hair are preferred and the local preference policy of user B may say that cats with short hair are preferred.

| |
|---|
| [New video, Duration 12 seconds, Resolution xyx] |
| [Generative model ID xyz, version vxyz] |
| [Background image: part in spring, sunny weather] |
| [Background sound: PREFERRED piano music'] |
| [Prompt: "small white cat"; Prompt_output: PREFERRED; Start time: 1 second; Duration: 10 seconds; Action: "walks from left to right"] |
| [Prompt: "big fat dog"; Prompt_output: #2; Start_time: 2 second; Duration: 9 seconds; action: "walks from right to left"; action: "smells cat and smiles"; action: "follows cat"] |

In general, these embodiments show that personalized content/data may be generated by means of, e.g., a personalized (generative) model and/or a personalized content program and/or a preference policy.

In a related embodiment, a receiving user/device and the transmitting user/device negotiate the decompression/content generation models based on the user preferences, network capabilities, capabilities of the receiving devices (e.g., CPU, rendering devices, etc) wherein the negotiation my involve none, one or more interactions. The transmitting device may profile the receiving device and assign one or more corresponding models. If one or more interactions are required, the receiving device may indicate to the transmitting device its preferences, and the transmitting device may then adjust the provided models accordingly.

In a related embodiment, the transmitting user/enterprise/device may offer one or multiple models to the receiving users and the receiving users may use one or more. For instance, a number of models may be available for the reconstruction of person voices. For instance, a number of models may be available for reconstructing persons/people in video data.

In a related embodiment, the transmitting user/enterprise/device may offer a data (e.g., audio visual data such as a movie) including a "package" of official models so that the end user can select his preferred one to perform decompression/rendering.

In a related embodiment, such data may include authorized models to be used that may include official ones or third-party ones, where allowed models are signed by the transmitting user/enterprise/device.

In a related embodiment, the transmitting user/enterprise/device may also be the data/content owner of the transmitted data/content wherein the data/content may be stored (e.g., in a cloud-based video streaming services such as Netflix) and the data/content may be streamed on demand.

In a related embodiment, the transmitting entity has a generic model that is personalized for the receiving entity, e.g., based on preferences given by the receiving entity. Then (only) the personalized model is provided to the receiving entity.

In a related embodiment, aspects that may be personalized and/or part of a model may include: the clarity of a dialogue (e.g., by choosing a clearer voice), aiding visibility (e.g., by changing the light or colour rendering or angle of view), the voice tone of the people, the emotional state of a person (happy, sad, etc.), the level of certain actions (e.g., violence, e.g., the same action: man A hits man B may be interpreted in a different way depending on the model preferences, e.g., harder or softer), etc.

In a related embodiment, data or content or signal may refer to images, audio, video, etc that are generated/transferred.

In a related embodiment, the model may be based on or used or be enhanced with a Generative Adversarial Network that is trained to adjust one data/content/signal's 'style' to resemble the style of another data/content/signal.

In a related embodiment, the decompressed output based on the usage of a generative model with the received prompts may be passed to a second model, e.g., a Generative Adversarial Network, to adjust the decompressed output/signal to fit / resemble the style of another "target/preferred" signal where the target/preferred signal is according to the preferences of the receiving user. In some examples, implementation systems and methods for the above embodiments in a cellular network environment (e.g., 5G) may be used, e.g., as described next or in other parts of this application.:
In connection with a scene observation, a "scene" is understood as meaning a true, observed reality, which is observed by some device using sensing to generate "scene observations" which should be compressed. For example, a device observing a visible scene using its camera generates scene observations in the form of image or video data. Instances derived from a segmentation process operating on the scene observations which are estimated to represent a semantically linked object, item, or person. For example, in an image of a person in a forest, a "forest" would be an object, as would a "person". A loss in realism between a regenerated output and the original scene observations is a semantic loss. This differs from the distortion introduced by traditional codecs in several ways; notably, by being much more dependent on the original objects being observed. Semantic Loss may thus exist in multiple types, some of which may only apply to certain modalities (e.g., images or video). Examples include object loss (e.g., categorial loss due to reconstruction of a different object to the one observed, e.g., a generic person instead of a specific person), colour loss (e.g., generation of correct objects with the wrong colour), focus loss (e.g., reconstruction of objects in-focus when they were out-of-focus in the scene observations, segment loss (e.g., reconstruction of the right objects in wrong locations), and motion loss (e.g.. loss of realism across time in a video which may occur for e.g., moving objects). Inputs (i.e., "prompts") to a reconstruction model (e.g., a diffusion model) have been learned or otherwise crafted so as to more closely describe a given object compared with a naïve prompt. Typically, learned prompts may be needed to enable reconstruction of objects which did not form part of the reconstruction model's training data set. An example would be the learned embeddings produced by textual inversion techniques (e.g., as explained above). A reconstruction refers to a reconstructed version of the scene observations (which may contain some residual error or loss, including semantic loss and conventional distortions). Finally, "ease of reconstruction" is understood as meaning a measure which takes into account both the resultant semantic loss, as well as compute requirements to generate a reconstruction for a given object using a given model from a given prompt.

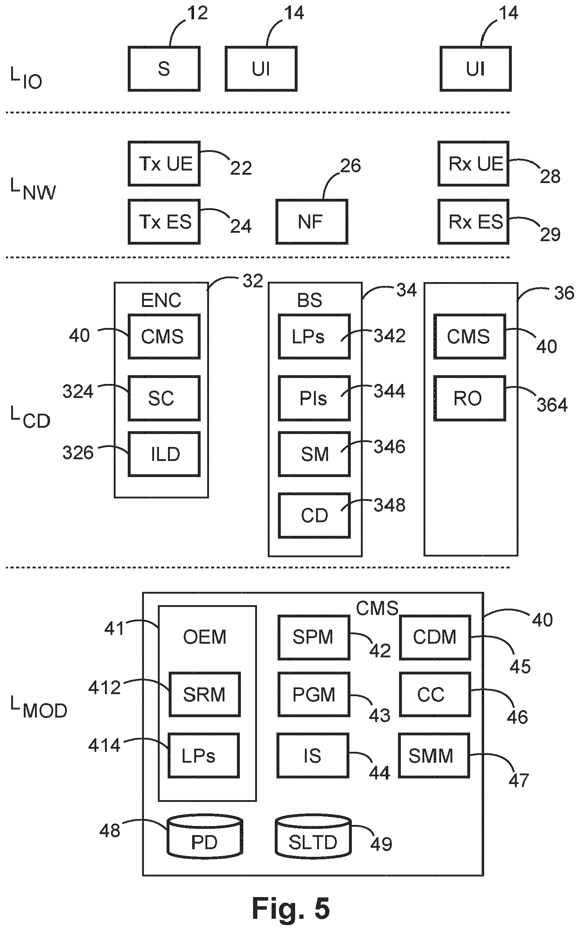

Fig. 5 schematically shows a block diagram of different layers involved in a compression system according to various embodiments.

IO and network (NW) layers (L_{IO} and L_{NM}) comprise a transmitting mobile terminal (Tx UE) 22 which may be a device such as a smartphone or AR glasses which implements sensing (S) 12 (e.g., allowing it to generate scene observations, e.g., via a camera) and a user interface (UI) 14 for input/output to a user, along with common networking and/or connectivity functions (e.g., Wi-Fi, 5G). Furthermore, a transmitting edge server (Tx ES) 24 is as an edge server local to the Tx UE 22 with high computational resources and a network connection. The Tx UE 22 has a networking connection to the Tx ES 24. Additionally, a network function (NF) 26 is a function that likely runs remotely from the Tx UE 22 and Tx ES 24 and provides bandwidth and throughput information, including in some cases predictively. The network function may, for example, be implemented as a trusted media function 26 which is accessed via a 5G system, e.g., as defined in 3GPP TS 26.501. Finally, a receiving mobile terminal (Rx UE) 28 and a receiving edge server (Rx ES) 29 are provided, which are similar to the Tx UE 22 and the Tx ES 24, respectively, except that neither of them may be configured to implement the sensing 12 to generate scene observations since they may be in some sense remote from the scene (either spatially and/or temporally).

Furthermore, a codec layer (L_CD) comprises an encoder (ENC) 32 capable of generating a bit-stream (BS) from input scene observations. The encoder 32 may be implemented as software and/or hardware by a suitable device (such as an edge server, e.g., TxES 24). The encoder contains or accesses a common model suite (CMS) 40 (described below) and scene comparator (SC) 324 which may be a software/hardware module for comparing reconstructions to the scene observations and calculating a loss score. For calculating distortion, the scene comparator 324 may implement data comparison algorithms, such as record checksum calculation algorithm or a matching algorithm or a correlation function (that determines whether two input data sets (e.g., the pixels of two images) are correlated or not, and how well) or a norm function (e.g., L2 norm that determines whether two input data sets (e.g., the pixels of two images) are close to each other, e.g., using the two norm. For calculating semantic loss, the scene comparator 324 may need to implement more task-specific algorithms, which may depend on the type of data being encoded. As an example, for an image containing people, the scene comparator 324 may implement face detection and recognition algorithms to determine how much a reconstructed face matches an observed face. For instance, it may implement algorithms to check that the reconstructed/decompressed images/sounds/data are semantically sound, e.g., check that all people have two hands with five fingers, or check that cats do not have winds,

Furthermore, the encoder may include an in-loop decoder (ILD) 326, which is a decoder for generating reconstructions (as described below).

The bit-stream 34, which is generated by the encoder 32 may contain at least one of learned prompts (LPs) 342, physical inputs (Pls) 344 (e.g., scene observations compressed using any kind of non-prompt codec, e.g., a conventional codec (CC) 46 of the common model suite 40 described below), a saliency map (SM) 346 (e.g., a map of the scene observation giving positions (in space and/or time) of objects together with an estimated saliency score, e.g., generated by a saliency mapping module (SMM) 47 of the common model suite 40 described below), and consistency data (CD) 348 (e.g., additional data generated by the encoder 32 and used to enhance consistency of reconstruction across spatial and/or temporal dimensions, e.g., generated by a consistency data module (CDM) 45 of the common model suite 40 described below).

Moreover, the codec layer comprises a decoder (DEC) 36 capable of taking the bit-stream 34 as input and producing reconstructions. The decoder 36 may be implemented as software by a suitable device (such as an edge server, e.g., RxES 29) and may contain or access the common model suite 40 described below and a reconstruction order (RO) module 364 which is configured to analyze the input bit-stream 34 and to determine an optimum order in which to create reconstructions of various objects on the scene observation. For this, the RO module 364 may implement a set of heuristics applicable to each object and may use feedback from hardware capabilities of the reconstruction device (for example, the RxES 29).

Finally, a model layer (L_{MOD}) comprises the common model suite 40 which contains at least one of shared reconstruction model (SRM) 412 (e.g., a machine learning model (most likely, a diffusion model) which takes prompts as inputs (including learned prompts (LPs) 414) and generates reconstructions as an output. Examples include the diffusion models described above. After an interaction has started, the base version of the SRM 412 can be put together with any new learned prompts 342 to constitute an overall effective model" (OEM) 41.

Furthermore, the common model suite 40 may comprise a prompt generation model (PGM) 43 for generating learned prompts for given objects within a scene observation. This may be achieved by using textual inversion to generate learned embeddings as described above, but any similar technique would also be suitable.

Additionally, the common model suite 40 may comprise an instance segmentation (IS) model 44 configured to, e.g., segment an input scene observation, to identify semantically linked objects, and/or to estimate the ease of reconstruction for those objects. The type of the instance segmentation model 44 may depend on the type of input, but as an example for images, a simple, fully-convolutional model for real-time instance segmentation as disclosed in Daniel Bolya: "YOLACT- Real-time Instance Segmentation", ICCV 2019 (retrievable at: https://openaccess.thecvf.com/content_ICCV_2019/papers/Bolya_YOLACT_Real-Time_lnstance_Segmentation_ICCV_2019_paper.pdf) would be suitable. A model for determining the ease of reconstruction model may for example implement an in-loop decoder (e.g., in-loop decoder 326) or be based on a set of heuristics.

The saliency mapping module 47 may be configured to generate a map giving a saliency score for a given segmented input, e.g., both per-object and optionally for regions within objects, wherein a hierarchy of objects may be applied. The type of model used by the saliency mapping module may depend on the type of input, but as an example for images, the model described in M. Ahmadi, M. Hajabdollahi, N. Karimi and S. Samavi, "Context-Aware Saliency Map Generation Using Semantic Segmentation," Electrical Engineering (ICEE), Iranian Conference on, Mashhad, Iran, 2018, pp. 616-620, doi: 10.1109/ICEE.2018.8472577 would be suitable. An alternative implementation may use a set of heuristics for saliency.

The consistency data model 45 may be configured to generate consistency data for a given object and/or for a scene observation as a whole. For this, several algorithms may be used, for example for per-object consistency data, a technique such as the guide-images of Zhihong Pan et al.: "EXTREME GENERATIVE IMAGE COMPRESSION BY LEARNING TEXT EMBEDDING FROM DIFFUSION MODELS", November 14, 2022 would be suitable. For consistency data for an overall scene observation, in-painting algorithms such as those described in Binxin Yang et al.: "Paint by Example: Exemplar-based Image Editing with Diffusion Models" would be suitable for spatial consistency within an image, and a technique such as that described in Shibani Santurkar et al.: "Generative Compression*"* operating on key-frames (for which a 'decay period' may be defined for which a keyframe is estimated to remain relevant) would be suitable for temporal consistency in a video (or other data type such as audio); or a more advanced technique such as that described in Gernot Riegler et al.: "Stable View Synthesis", CVPR 2021.

The conventional codec 46 which can compress scene observations according to conventional algorithms may include a non-generative compression codec (e.g., JPEG, H.265, etc.).

A scene prediction model (SPM) 42 may be provided as part of the common model suite 40 and may be configured to predict changes to scene observations before they occur. As an example, for video inputs, next-frame prediction models may be used, which is configured to predict what happens next in the form of an image or a few images. This prediction may be built on an understanding of information in historical images that have occurred so far. It may refer to starting from continuous, unlabeled video frames and constructing a network that can accurately generate subsequent frames. The input of the network may be the previous few frames, and prediction is/are the next frame(s). These predictions can be not only of human motion but also for any object motion and background in the images. Modeling contents and dynamics from videos or images is the main task for next-frame prediction which is different from motion prediction. Next-frame prediction is to predict future image(s) through a few previous images or video frames whereas motion prediction refers to inferring dynamic information such as human motion and an object's movement trajectory from a few previous images or video frames.

Moreover, the common model suite may comprise or have access to at least one of a semantic loss types database (SLTD) 49 for storing different types of semantic loss and their relevant weighting and/or a prompts database (PD) 48 for persistently storing learned prompts (which may be persistent beyond the time of an interaction).

There may further be a side channel for object databases to efficiently transmit video of particular genres, wherein decoders fetch from such object database once when a video has such labels.

Additionally, there may be a general object database e.g. as part of a standard (or of a system or of a technology or of a product), wherein all decoders according to that standard are configured to recognize labels of this general object database. These labels may have namespaces to indicate which database they belong to. A video may use multiple namespaces.

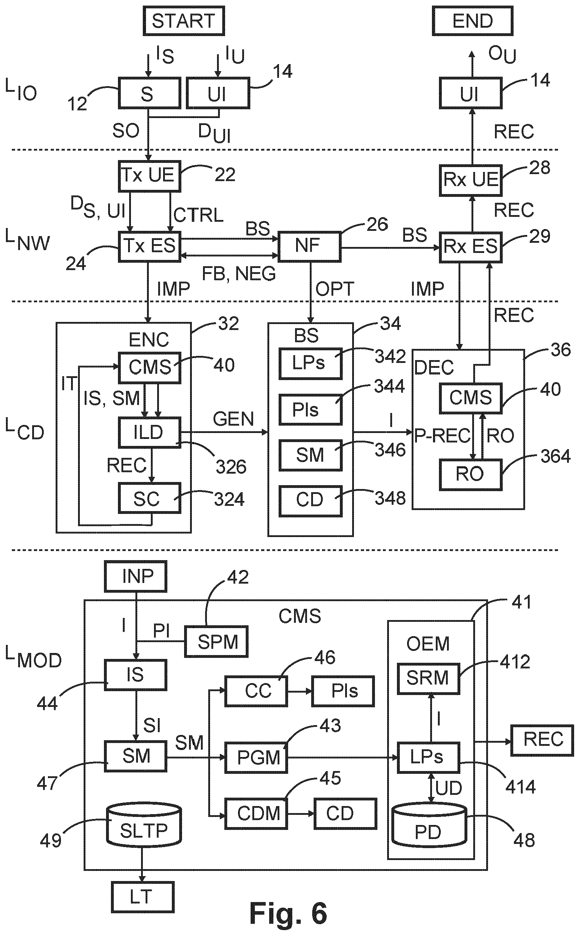

Fig. 6 schematically shows a flow diagram of a compression and decompression process according to various embodiments using the different layers of Fig. 5. It is to be noted that not all steps may always be required, that the sequence of the steps may be adapted and that some steps may be executed multiple times. For instance, for compression, the scene does not need to be sampled/sensed.

Input I_{S} ,e.g., at the start of the process, from a scene via the sensing function 12 and/or input Iᵤ from a user via the user interface 14 in the IO layer is converted to scene observations and UI data of the TxUE 22 in the network layer, which forwards corresponding scene and UI data to the TxES 24 and exchanges control information with the TxES 24.

It is noted that the above example applies if a user wants to send an image to another user. As an alternative, the user could enter prompts directly and send them to the other side. For instance, the user may try a prompt "Sweet cat", the local model generates four cats, the user selects one of them (e.g., #2), and then the user decides to send prompt ["Sweet cat", #2] to the other party. In this case, the input in the UI does not require further compression.

The TxES 24 implements the encoder 32 in the codec layer which accesses the common model suite 40 to obtain an instance segmentation and a saliency map and learned prompts and forward them to the in-loop decoder 326 which generates a possible reconstruction to be compared by the scene comparator 324 to the real scene observation. This loop is iterated until a desired semantic loss has been reached. Based thereon, the encoder 32 generates (GEN) the bit-stream 34 to be used as input (I) for the decoder 36 at the receiving end, which accesses the common model suite 40 to obtain partial reconstruction(s) to be supplied to the RO module 364 for generating a reconstruction order (RO).

In the network layer, the TxES 24 transmits the generated bit-stream 34 to the network function 26 which optimizes the bit-stream (BS) 34 and forwards the optimized bit-stream 34 to the RxES 29 which implements the decoder 36 in the codec layer and obtains reconstruction(s) (REC) output from the decoder 36. Furthermore, the TxES 24 and the network function 26 exchange feedback (FB) and negotiation (NEG) messages e.g. for controlling the bit-stream optimization process. The RxES 29 forwards the reconstruction to the RxUE 28 in the network layer and the RXUE 28 supplies the reconstruction (REC) to the user interface 14 in the IO layer to generate a corresponding output (Oᵤ) for the user to end the process.

In the model layer, the common model suite 40 receives input (INP) from the TxES 24 or the RxES 29 or optional predicted input (PI) from the scene prediction model 42. Based thereon, the instance segmentation module 44 generates a segmented input (SI) to be forwarded to the saliency mapping module 47 which generates a saliency map (SM) which is supplied to the conventional codec 46, the prompt generation model 43 and the consistency data model 45. Based on the received saliency map, the conventional codec 46 generates physical inputs (PIs), the prompt generation model 43 generates learned prompts 414 for updating (UD) the prompts database 48 the overall effective model 41, and the consistency data model 45 generates consistency data (CD). The overall effective model 41 uses the generated learned prompts as input (I) to generate and output a reconstruction (REC) for the RxES 29. The semantic loss types database 49 may be used to output loss types (LT) to the scene comparator 324 of the encoder 32 in the codec layer.

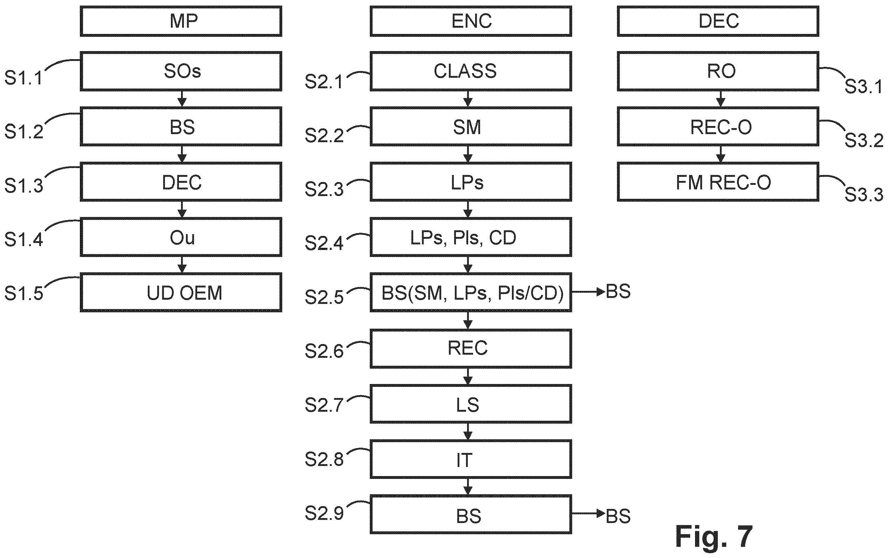

Fig. 7 schematically shows flow diagrams of different processes (i.e., a main process (MP), an encoding process (ENC) and a decoding process (DEC)) involved in a compression and decompression process according to various embodiments, in which two devices implement generative compression across a network with feedback from a network function. It is to be noted that not all steps may always be required, that the sequence of the steps may be adapted and that some steps may be executed multiple times.

More specifically, the different processes of Fig. 7 include a part are relevant to networking (i.e., the main process), and two parts relevant to the proposed codec functions (i.e., encoder 32, bit-stream 34 and decoder 36 in Figs. 5 and 6).

In some optional embodiments related to the above first type of system, data may be compressed and stored locally to a first device (e.g., the TxUE 22). In this case, the encoder 32, bit-stream 34 and decoder 36 of Fig. 5 may be substantially the same or provided in the same device (first device), while in the main process, the first device would simply store rather than transmit the bit-stream.

In step 51.1 of the main process, scene observations are generated via sensing (which may be local to the transmitting device (e.g., the TxUE 22) or via an external device).

A scene may also be generated from prompts. Consider a movie maker that uses prompts and an existing model to create the scene by writing text commands. In an example, an app that may run on a mobile phone that allows a user to create videos/music from prompts and a model, and the user can then share those videos/music with other users.

Optionally, user input may be collected via a UI. At least some aspects of the scene observations may be forwarded to an transmitting edge server (e.g., the TxES 24). Whether to forward the entire scene observations or only some aspects of that (for example, specific objects) may depend on several factors including the hardware available at the transmitting device, e.g., whether it is able to locally generate learned prompts, whether the transmitting edge server is available with low latency, etc. These considerations may be largely similar to those involved in split rendering, as explored for example in the 3GPP TR 26.803 study on 5G media streaming extensions for edge processing.

In step S1.2, the transmitting edge server implements an encoder to generate a bit-stream representing the scene observations. The transmitting edge server may negotiate with a remote party (e.g. a network function) to derive a bandwidth target for the generated bit-stream, which is passed to the encoder as an additional input. The network function may provide, for example, an available bandwidth for the transmission of the bit-stream. The transmitting edge server commands the encoder to produce a bit-stream which fits within this target and use an in-loop decoder and a scene comparator to estimate its semantic loss by comparing the reconstruction to the original scene observations. The encoder may generate further bit-streams using different settings and may calculate their semantic loss similarly. The main way in which these bit-streams would differ would be the use of learned prompts for more or fewer objects (with the remaining objects represented by physical inputs), thus generating a smaller or larger (i.e., more or less compressed) bit-stream, respectively.

Where, for example, a bit-stream which is only slightly larger than the originally set bandwidth limit can obtain a much lower semantic loss, the encoder may flag this to the transmitting edge server, which may then negotiate with the network function to be assigned a slightly larger bandwidth temporarily. This may occur where, for example, an input contains many uncommon or unique objects, which would be associated with higher semantic loss.

Conversely, where an input contains many generic objects, the encoder may be able to achieve a very low semantic loss even at very low bandwidth, and so it may flag this to the network function which may release unnecessary bandwidth resources for other processes. The amount of additional bandwidth which is acceptable to apply to achieve a given reduction in semantic loss may be subject to user input or operator policy.

In step S1.3, the bit-stream may be stored in a database and/or transmitted to the receiving edge server (e.g., RxES 29) via a network. The receiving edge serve implements a decoder (see below) to decode the bit-stream. The decoder generates reconstructions in a format useable by the receiving edge server and the receiving device (e.g., the RxUE 28).

In step S1.4, the receiving edge server forwards the decoded (decompressed) bit-stream to the receiving device to generate user output.

Given the generated learned prompts (which are now available to both transmitting and receiving edge servers), the overall effective model is updated in step S1.5 and may be used by both encoder and decoder in place of the base version of the shared reconstruction model.

The decoder may store learned prompts it receives from the bit-stream in the prompts database for future use. This may be especially relevant where the encoder has included consistency data (for example, the above mentioned guide images) to aid in the reconstruction of a given learned prompt. In that case the reconstruction of that object generated with the consistency data can be stored alongside the learned prompt. Next time the same object should be transmitted, the transmitting edge server may only then need to generate and transmit the learned prompt and no or less consistency data, saving compute and bandwidth resources.

The prompts database may optionally be persistent beyond the time frame of one interaction. This would allow for storage of learned prompts (and any necessary consistency data), alongside their semantic description, for future interactions in which the same objects may be observed. Storage may be local on the end receiving device, or in a local/close edge server, e.g., an edge server of a content delivery network or a video streaming service. This may lead to several optional network-side additions to the method, including a side channel for prompt databases to efficiently transmit inputs of a particular type (for example, video of particular genres) and decoders may fetch (from) the related prompts database once when an input of a matching genre is detected, or a general object database that is part of a standard where all decoders according to that standard recognize all these learned prompts in a known way, or namespaces provided for learned prompts to indicate which database they belong to, wherein a particular input (e.g., a video) may require the use of multiple namespaces.

In step S2.1 of the encoder related process, the encoder (e.g., encoder 32) takes scene observations as input. It uses the instance segmentation model to classify the scene observation into bounded instances representing linked objects. Instance segmentation is a process of detecting connected regions in the image and assigning a category to each connected region. Two or more regions may receive the same category label but can still be identified separately since they constitute different instances of the same object category (e.g., multiple people). The instance segmentation model classifies the segmented objects according to ease of reconstruction via a base version of the shared reconstruction model.

The ease of reconstruction calculation may occur naively (i.e., by using the in-loop decoder to create a reconstruction of the object in question, comparing it to the scene observations, and calculating the semantic loss), or via a set of heuristics (e.g., generic objects may be estimated to have a higher ease of reconstruction than specific people).

In step S2.2, the encoder may further use saliency mapping to estimate the saliency of the segmented objects. As an example, the salience of objects in an image may depend on their type and position (e.g., human faces in the foreground may have the highest saliency). Saliency may be further be calculated within an object (e.g., key points on a face). The obtained saliency data may be stored in a space or time-resolved format, matched to the format of the scene observation, to produce a saliency map.

In step S2.3, for selected observations (e.g., those with high ease of reconstruction via the share reconstruction model, and/or of lower saliency), the encoder uses the prompt generation model to locally generate potentially suitable learned prompts (LPs) representing those objects, and places them in the bit-stream. The Encoder may further generate global consistency data (CD). In this way the easy and/or unimportant objects are placed into the bit-stream with minimum size (i.e., a learned prompt only, with no per-object consistency data). What level counts as "lower" saliency and "higher" ease of reconstruction may depend on any bandwidth target the encoder has been commanded to hit and/or possibly, user, system or operator policy.

The global consistency data may take several forms. For example, data to ensure spatial consistency of regenerated objects in an image. This could be a segmentation mask giving the positions in which objects should be reconstructed. Where two or more objects are to be reconstructed from different learned prompts, the consistency data may include partially masked inputs (e.g., masked images), showing how the masked area is the region that corresponds to the portion that is predicted by a first (text) prompt, whereas the unmasked region corresponds to the portion that is predicted by a second (text) prompt. The decoder (see below) can be applied recursively to fill the entire image using multiple prompts.

An alternative to dealing with multiple objects may be to use instance segmentation on an intermediate image resulting from the prompt-generated output. Consider that a given category instance is segmented in the source image. A prompt that can synthesize this category instance can be generated in isolation or in a suitable context that matches the context of the source image. An intermediate image is now synthesized just for this single instance. Then, an object instance segmentation is applied again, but now on the intermediate synthesized image to isolate the segment that shall be placed in the final image. The segment still needs to be cropped, translated and scaled to best fit the segment in the source image. To determine these parameters, the set-theoretic intersection over union (IoU) metric between the source image segment and the intermediate image segment may be maximized. The crop, translation and scale parameters need to be transmitted with the (text) prompt. In this scenario, instance segmentation also needs to run at the decoder side.

Another form of global consistency data may be data to ensure temporal consistency of video generated from prompts, including situations of relative motion between the scene and the camera. For example, this could take the form of an estimated decay time (number of frames) over which the prompt is expected or known to be valid. The prompt may optionally be used past this decay time but at the cost of increasing semantic loss. This is similar to operating on keyframes and infills between them, with the addition of a decay time estimate.

Another technique which would be relevant is the above mentioned concept of optic flow to train a "motion-aware" branch of a reconstruction model, which is used to predict the error in an interpolation branch. In this case, the consistency data may consist of the motion-aware branch.

In a case where objects in a scene only follow camera motion and the camera only rotates or zooms, no parallax is introduced and the (text) prompt can remain constant over time and additional global camera motion parameters may be placed in the bitstream to motion compensate the image part that is synthesized from the text prompt. Temporal colour/light changes can also be transmitted. This approach is applicable for certain background categories such as mountains in the background, a street with houses in the background, a forest in the background.

A further form of global consistency data may be data to ensure matching between scene observations of different modes (e.g., audio matched to video frames) where those are both regenerated from prompts. This could include matched 'decay times' for the audio and video prompts (as above). In some scenarios, it may be possible to train a reconstruction model which reconstructs both audio and video from a shared latent space, and design prompts for that latent space, which would natively take care of temporal matching. Optionally, only one mode (e.g., only the video) may use generative compression and the consistency data forces the audio to use a conventional codec, and then provides a simple timeline matched to the audio in which the video prompts should be reconstructed.

A further form of global consistency data may be data to resolve ambiguities in audio inputs. For example, the learned prompts may relate to two overlapping voices. In this case, it may be more efficient to have more than one learned prompt in this case (e.g., voice A, voice B, and specify a degree of overlap via the consistency data).

In step S2.4, for the remaining segmented observations, the encoder may be configured to perform at least one of generating learned prompts (tolerating higher predicted semantic loss), using a conventional codec to generate physical inputs (PIs) representing those objects (tolerating higher bandwidth usage), and generating pre-object consistency data which acts as a correction to the above learned prompts.

The per-object consistency data may take several forms. This may for example use the above mentioned guide-image technique to act as a correction on the regeneration of images from learned prompts. To ensure colour consistency in an image, the consistency data may include a calculated colour transform vector that modifies colour for a given object or spatial region of an object to better fit the scene observations. The same may be done using a texture transform for rendering complex textures. Since color and texture transform parameters are specified per object, the rate-distortion formula becomes: *L*ₜₒₜₐₗ = *L*_{conventional} + *ΣᵢLᵢ* where the summation is over all text-prompt generated regions *i.* A text-prompt generated object/region *i* leads to *Lᵢ*(*k*;**p**) = *kᵢRᵢ*(**p**) + *Dᵢ*(**p**). Note that the rate/distortion balance, specified by parameter *kᵢ* can be chosen differently depending on object category. The color and texture transform parameters provide an option to bring the synthesized image close to reality by either applying a per-object color transform or by adding/modifying spatial textures. For example, the appearance of a 'wooden chair' as generated from the text prompt can be made more like the real chair by increasing/decreasing the spatial frequency of synthesized textures inside the object. Parametrized simple high-pass or lowpass filters may be used to achieve these effects. The distortion term *Dᵢ*(**p**) for object/region *i* can be split into a colour and a texture term: *Dᵢ*(**p**) ≡ *D*_{*i*,colour}(**p**_{colour}) + D_{*i*,texture}(**p**ₜₑₓₜᵤᵣₑ) where **p** is the combined vector of colour and texture parameters. The colour distortion term *D*_{*i,*colour}(**p**_{colour}) can be calculated using a distance function between distributions. Texture distortion term D_{*i*,texture}(**p**ₜₑₓₜᵤᵣₑ) can be calculated by comparing spatial frequencies between the synthesized texture in object object/region *i* and the observed image.

The reconstruction from the learned prompts of step S2.3 may serve as a predictor for at least part of the input, and a conventional codec may be used to compress the residual input (where the conventional codec operates on the entire residual input rather than specific objects). This is analogous to enhancement of encoding with a diffusion model based base layer and conventional enhancement layer.

The reconstruction using the learned prompts of step S2.3 may serve as one reference frame that is used by a conventional codec to encode other frames (especially relevant for video).

In step S2.5, the encoder may optionally terminate, generating a bit-stream containing the saliency map, learned prompts, and any required physical inputs or consistency data, with an optional estimated loss score.

In step S2.6, the encoder may use the in-loop decoder which accesses the shared reconstruction model to generate an initial reconstruction using the initial version of the saliency map, learned prompts, physical inputs, and consistency data. This initial reconstruction is passed to the scene comparator. In subsequent runs of the encoder, this step may use the overall effective model rather than the shared reconstruction model to account for any already-transmitted learned prompts.

In step S2.7, the scene comparator may compare the initial reconstruction to the scene observations and generate or update the loss score (both semantic loss and, where physical inputs have been used, conventional compression loss). For semantic loss, the scene comparator may aim to identify objects which have contributed highly to the semantic loss score. For such objects, the encoder may attempt to generate consistency data (as above) to lower the loss score.

In step S2.8, the encoder may iterate, generating new learned prompts, consistency data and physical inputs until a desired loss score has been achieved.

Finally, in step S2.9, the encoder may place, e.g., its learned prompts, consistency data, physical inputs, saliency map, or other encoded data into the bit-stream.

The decoder process may start with step S3.1, where the decoder (e.g., the decoder 36) receives the bit-stream as input. It uses the reconstruction order module to calculate an optimum reconstruction order to generate a reconstruction from the learned prompts and any physical inputs. This may take into account both estimated speed of reconstruction or saliency from the saliency map. The RO module may implement several heuristics to calculate a reconstruction order.

For example, one such heuristic may state that physical inputs can be reconstructed faster than the learned prompts using a given receiving edge server, and as such, the learned prompts should be executed first in order to accelerate the overall reconstruction.

A second example is reconstruction of objects with higher saliency (from the saliency map) first (for example, reconstructing the foreground before the background).

A third example is reconstructing objects which have both learned prompts and consistency data associated with them by using the learned prompt only initially, then adding the consistency data later, where this may lead to a quicker initial reconstruction (even at the expense of higher semantic loss).

Where necessary, known stitching and smoothing techniques may be employed to hide the transition between different versions of reconstructed objects.

In step 53.2, the decoder may use a shared reconstruction model (or the overall effective model in later iterations) to reconstruct objects from its received learned prompts according to the reconstruction order. One or more shared reconstruction models may be used, e.g., depending on the data type. The shared reconstructed model that is used may be based on the preferences or a profile of the receiving device. The reconstruction model may refer to one or more than one chained reconstruction models. For instance, a first reconstruction model may reconstruct/generate audio/video/etc. generic data from the received prompts and a second reconstruction model may generate personalized audio/video/etc. data taking as input the generic data. It also generates outputs using the conventional codec for the received physical inputs. The saliency map may be used to achieve a correct placement of the reconstructed objects to generate an overall reconstruction of the scene observation. Additional, global consistency data may be used to ensure (for example) temporal stability of the reconstructed output.

The global consistency data may consist of several things depending on the form of the scene observations. Examples may include at least one of a simple set of masks for an image giving the placement of objects (to ensure spatial consistency), a temporal version of the above for audio/video, and information required to enhance the consistency of video reconstructed from prompts (for example a 'decay time' over which a prompt is expected or known to be valid and after which continued use of the prompt may lead to increased semantic loss).

In step 53.3, the decoder may pass the reconstructed output in a useable format to downstream functions (for example, the receiving device).

According to alternative predictive embodiment, in addition to comparison of the initial reconstruction to the scene observations, the encoder may also or instead compare it to a predicted version of the scene observations, generated by the scene prediction model 42 of Fig. 6. Where this occurs, the above processes of Fig. 7 may be modified as indicated below.

At step S2.1, in addition to or instead of taking scene observations as input, the encoder takes a predicted scene some time ahead from the scene prediction model. The time period ahead over which to make the prediction may be set using at least one of data from the scene prediction model (which may output an estimated time period over which its predictions are expected to be valid), a required latency input from the network function (where a lower required latency would imply predicting scene observations over a longer period ahead), an acceptable semantic loss (where a lower loss would imply a shorter prediction period), and a user, system, or operator policy. Furthermore, the time period over which the prediction is expected to remain accurate (i.e., the 'decay time') may be added to the consistency data.

At step S2.6, in addition to or instead of comparing the initial reconstruction to the scene observations, the scene comparator may compare it to the predicted scene some time ahead.

At step S2.9, the encoder may generate prompts, physical inputs, consistency data and initial reconstructions for this predicted scene as outlined in the main method and passes it to the transmitting edge server which transmits it to the receiving edge server. The receiving edge server can now create reconstructions of scene observations with zero or even negative latency, by ensuring that the receiving device displays the appropriate predicted reconstruction at the time at which it is predicted to occur.

Optionally, the transmitting edge server may wait until the real scene observations are available for the time period which has been generated predictively. It may then command the encoder to use the scene comparator to compare the true scene observations to the expected predictive reconstruction generated from its predictive bit-stream. Where there are significant differences between the predictive reconstruction and the true scene observations (i.e., a high semantic loss score), the transmitting edge server may command the encoder to generate additional consistency data to act as a correction factor for those differences. This consistency data may be per-object or global. The transmitting edge server may transmit the consistency data to the receiving edge server which may apply this corrective data to update its reconstructed objects, optionally using smoothing techniques to mask the transition.

Alternatively, the receiving edge server may implement the scene prediction model to also make a prediction based on its already-received reconstructed scene observations. In that case, the receiving edge server may use the additional step of optionally choosing to transmit its prediction back to the transmitting edge server, so that it can be compared to the true scene observations once they become available. The transmitting edge server may then generate and transmit suitable predictive consistency data for the predictive reconstruction at the receiving edge server.

Fig. 8 schematically shows processing steps and outputs of an exemplary embodiment.

In step S161, a transmitting device (e.g., UE) observes a scene (upper large image in Fig. 8) including a forest area (F) which is easy to reconstruct and an unknown person (UP) which is impossible to reconstruct initially. It thus classifies (CLASS) the forest area as "easy to reconstruct". Then, in step S162, the transmitting device generates a prompt for both easy and difficult objects and transmits the easy ones (e.g., "a forest") first, as indicated in the small upper right image of Fig. 8.

In step S163, the transmitting device uses network feedback to handle the difficult object with increasing level of semantic loss to optimize bandwidth (OPT-BW). To achieve this, it first generates a generic person (GP), as indicated in the small middle image of Fig. 8. Then, it obtains a correction image (CORR-IM) with low to medium loss and high computation burden by comparing or having compared its best prompt to the physical image (PHY-IM) of the actual observed scene without semantic loss (small lower image in Fig. 8).

In step S164, the transmitting device may transmit the best prompt with small physical correction image to the receiving device.

Similar steps can be performed at the receiver side that takes the prompt and a reconstruction model to reconstruct the content, an image in this case. Different receivers may have been configured with different reconstruction models so that the reconstructed content better fits the preferences of the receiver. For instance, the original forest may be reconstructed for a first person living in Brazil as a jungle, for a second person living in Norway a pine forest, and for a third person living next to the beach as a beach. For instance, some aspects of the reconstructed person (e.g., skin tone, eye shape, mouth shape, etc.) may also be reconstructed to better fit the preferences of the receiver. This may also imply that one or multiple correction images may need to be available and/or transmitted.

Throughout the above embodiments, the applications, e.g., metaverse or teleconferencing or video streaming, etc, making use of the communication infrastructure may be capable of configuring and using the communication infrastructure for optimized performance. This configuration and usage may be done through the tactile service manager (TSM) that coordinates the underlying networks and communications. A 5G (or 6G) TSM may be present in the 5GS (or 6GS). The 6G TSM may interact with the 5G TSM. Furthermore, the configuration may be controlled by means of a policy which may include configuration items for each tactile device (TD) in each tactile edge (TE). Every time a new TE (TD) joins a (new) (metaverse) communication session, the application may add entries to the policy corresponding to the new TD or TE. The TSM and/or application may also coordinate the preferences of the transmitting/receiving entities and may adapt, correspondingly, the encoding/communication parameters, e.g., models used. For instance, the TSM may distribute the policy of the new TD (TE) to all existing TDs (TEs) already involved in the (metaverse) communication session. Additionally, the TSM may distribute the policy including entries of all existing TDs (TEs) already involved in the (metaverse) communication session to the new TD (TE). The configuration may be a one-time configuration or may be a metaverse session configuration for a metaverse session between a number of TEs (e.g., a number of users (A, B,..., i,...)).

Moreover, the configuration may include a policy specifying, e.g., QoS goals depending, e.g., on number of users, relative latency, need of continuous monitoring of the latency between TEs as well as update rate of parameters as explained in other embodiments, latency requirements for each of the TD in a TE, need of QoS equalization, and if applicable, so that compression schemes or models and/or a predictive model of each TD in a TE may be correspondingly adapted, or the TSM can deploy the model or a compressed model to the other TDs/TEs in a communication session.

Similarly, the communication infrastructure may also inform the (metaverse) application about communication parameters and/or configure the (metaverse) application.

It is to be noted that the transmitting and receiving devices maybe far or close, and therefore, the transmitting TE and receiving TE may be collocated. It is to be noted that the TE is not always required.

Unicast communication flows may require keeping unicast flows per sensing TD (N devices) towards each actuator/rendering TD (M devices). This can become less efficient as N and M increase. A more efficient approach consists in a multicast approach in which each sensing TD multicasts its flow and the flow is distributed to each of the subscribed rendering TDs. This involves N multicast flows even if it is still important to consider that the multicast flow may reach different rendering TDs/TEs at different instants of times, and those TDs/TEs receiving the multicast flow earlier may use, e.g., a compressed model of the sending TD/TE while those TDs/TEs receiving the multicast flow later might require, e.g., a less compressed model.

Furthermore, the architecture of the proposed compression system may be enhanced for or used to enhance the, e.g., next generation real time communication or multicast and broadcast services. For instance, 3GPP specification TR 23.700-87 v1.0.0 describes 5G system architecture enhancements for next generation real time communication including IP multimedia subsystem (IMS) network architecture enhancements required to support AR telephony communication for different types of AR-capable UEs, and IMS procedures including signalling and media processing need to be changed to support AR telephony communication. Solutions #8 and #9 in TR 23.700-87 specification address these architecture enhancements. In TR 23.700-87, it is concluded that the data channel architecture is used as baseline to support AR telephony communication. If the UE needs network support for media rendering, the architecture and procedures specified in Solution #9 are used. Otherwise, if the UE can perform the media rendering without network support, the procedures as specified in Solution #8 are taken as baseline for terminal rendering process.

In an embodiment, the system and functionalities described in solution #8 in TR 23.700-87 may be extended to support at least some of the embodiments described above. Figure 6.8.2-1 in TR 23.700-87 describes a communication flow between two UEs including three procedures: (1) IMS multimedia telephony call; (2) bootstrap Data Channel (DC) establishment; and (3) application DC establishment.

In a further embodiment, the system and functionalities in solution #9 in TR 23.700-87 may be extended to support at least some of the embodiments described above. Figure 6.9.2.2-1 in TR 23.700-87 describes a communication flow between two UEs with a network rendering process in which an AR media processing network function (ARMF) is responsible for AR communication media transmission and media rendering function, including the functions of an AR rendering logic that controls an application-based rendering logic of AR communication, and AR media processing function including a vision engine and a 3D rendering engine, which may establish a spatial map and render the scenes, virtual human models and 3D object models according to the field of view, posture, position, etc. which are transmitted from UE using data channel.

Different embodiments may be combined with each other or may be used independently as required to address requirements and/or missing capabilities.

To summarize, apparatuses and methods for data compression/decompression have been described, wherein input observation data is classified into types of semantic objects according to one or more criteria and a compression technique is applied to the object types based on their ease of reconstruction via a compression model to obtain compressed data. The classification may be performed based on the performance of the compression model. A suitable descriptive prompt may be generated, e.g., based on a textual inversion technique, for a data object belonging to a data object type that can be well reconstructed. Furthermore, apparatuses and methods for personalized data compression/construction/decompression/reconstruction have been described, wherein an encoder/decoder takes a suitable personalized descriptive prompt (or program) and/or a personalized reconstruction model and/or a personalized policy to generate personalized content according to the user's preferences and/or profile. Although this invention was described in the context of virtual space such as metaverse, its applications are not limited to such a type of operation. Low latency systems, e.g., in Industrial IoT systems, would also benefit from the teachings of this invention and its embodiments.

Furthermore, this invention can be applied to various types of UEs or terminal devices, such as mobile phone, vital signs monitoring/telemetry devices, smartwatches, detectors, vehicles (for vehicle-to-vehicle (V2V) communication or more general vehicle-to-everything (V2X) communication), V2X devices, Internet of Things (IoT) hubs, IoT devices, including low-power medical sensors for health monitoring, medical (emergency) diagnosis and treatment devices, for hospital use or first-responder use, virtual reality (VR) headsets, etc.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. The foregoing description details certain embodiments of the invention. It will be appreciated, however, that no matter how detailed the foregoing appears in the text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated. Additionally, the expression "at least one of A, B, and C" is to be understood as disjunctive, i.e., as "A and/or B and/or C".

A single unit or device may fulfil the functions of several items recited in the claims. The mere fact that certain measures are recited in mutually different dependent claims does not indicate that a combination of these measures cannot be used to advantage.

The described operations like those indicated in the above embodiments may be implemented as program code means of a computer program and/or as dedicated hardware of the related network device or function, respectively. The computer program may be stored and/or distributed on a suitable medium, such as an optical storage medium or a solid-state medium, supplied together with or as part of other hardware, but may also be distributed in other forms, such as via the Internet or other wired or wireless telecommunication systems.

## Claims

1. An apparatus (32) for data compression, wherein the apparatus (32) is configured to segment input data to produce instances relating to identified semantic objects according to one or more criteria; and to apply a compression technique to the identified semantic objects.

2. The apparatus (32) of claim 1 wherein the apparatus (32) generates a descriptive prompt (342) for a semantic object belonging to a data object type that can be represented or reconstructed with no more than a minimal semantic loss by means of the descriptive prompt (342) and a compression model (322).

3. The apparatus of claim 1 or 2, wherein the apparatus is configured to apply the compression technique based on at least one of:
- an ease of reconstruction of the identified semantic objects,
- semantic-loss requirements,
- personalization requirements,
- compression needs,
via a compression model (322).

4. The apparatus (32) of claim 2, wherein the apparatus (32) is configured to synthesize an image using the generated descriptive prompt (342), to run instance segmentation on the synthesized image, to determine at least one of a crop parameter, a translation parameter and a scale parameter, and to output the determined parameter together with the descriptive prompt (342).

5. The apparatus (32) of claim 2, wherein the apparatus (32) is configured to perform temporal data association of generated descriptive prompts (342) for frames of the input observation data over time, and to determine parameters of a global motion model for each instance associated with a generated descriptive prompt (342).

6. The apparatus (32) of claim 2, wherein the apparatus (32) is configured to compress a data object belonging to a data object type that cannot be represented or reconstructed with minimal semantic loss by means of a descriptive prompt (342) and the compression model (322), by at least one of the following:
a. generating an estimated descriptive prompt suitable to retain sufficient semantic content for a given context;
b. developing a descriptive prompt based on textual inversion guided by the data object; and
c. using a conventional compression technique.

7. The apparatus (32) of any one of the preceding claims, wherein the apparatus (32) is configured to label compressed data objects according to the used compression technique and/or reconstruction model (412).

8. The apparatus (32) of any one of the preceding claims, wherein the apparatus (32) is adapted to be configured with or to negotiate a compression policy by/with a communication manager (26), and wherein the compression policy determines at least one of an allowed quantity of semantic loss, a desired compression ratio, a desired computational overhead, a desired storage overhead and a desired communication overhead.

9. An apparatus (36) for data decompression, wherein the apparatus (36) is configured to receive compressed semantic objects and to apply a decompression technique based on the compression model (326) and a type of the received compressed semantic data objects to obtain decompressed data.

10. The apparatus of claim 9, wherein the decompression technique relies on at least one of a personalized compression model, a personalized policy, and a personalized prompt to obtain personalized decompressed data.

11. The apparatus (36) of claim 9 or 10, wherein the apparatus (36) is configured to decompress at least one of the compressed semantic objects based on a shared reconstruction model (412) and a descriptive prompt (342).

12. The apparatus (36) of any one of claims 9 to 11, wherein the apparatus (36) is configured with a decompression policy that has been negotiate with or configured by a communication manager (26).

13. The apparatus (36) of any one of claims 9 to 12, wherein the apparatus (36) is configured to determine and update the compression model (362) based on a reconstruction performance.

14. The apparatus (36) of any one of claims 9 to 13, wherein the apparatus (36) is configured to use a received descriptive prompt (342) for predictive decompression.

15. A system comprising a transmitting device (22) comprising an apparatus (32) according to claim 1, and a receiving device (28) comprising an apparatus (36) according to claim 9, wherein the transmitting device (22) is configured to share the compression model with the receiving device (28), and wherein the shared compression model (322) is determined or updated based on a reconstruction performance and/or receiver preferences.

16. The system of claim 15, wherein the receiving device (28) is configured to compare predicted decompressed data with the obtained decompressed data to determine a correction factor.

17. The system of claims 15 or 16, wherein the transmitting device (22) is configured to predictively generate the descriptive prompt (342) and to compare decompressed data that has been decompressed based on the predicted descriptive prompt (342) with the input observation data to determine a correction factor.

18. The system of claim 16 or 17, wherein the receiving device (28) is configured to receive the correction factor from the transmitting device (22) from which the compressed semantic objects have been received, and to use the correction factor to correct the obtained decompressed data.

19. The system of any one of claims 16 to 18, wherein a shared reconstruction model (412) is re-trained based on the correction factor.

20. The system of any one of claims 15 to 19, wherein a semantic loss is determined based on an instance rate distortion function, wherein a total loss is summed over a plurality of semantic objects identified in the input observation data, and wherein an object loss consists of an object rate and an object distortion which depends on object color and texture parameters.

21. A method for data compression, comprising:
• segmenting input observation data to produce instances relating to identified semantic objects according to one or more criteria; and
• applying a compression technique to the identified semantic objects based on their ease of reconstruction via a compression model (322).

22. A method for data decompression, comprising:
• receiving compressed semantic objects; and
• applying a decompression technique based on a compression model (326) and a type of the received compressed semantic objects to obtain decompressed data, wherein the compression model and/or compressed semantic objects depend on at least one of decompression performance requirements, semantic loss requirements, and user preference requirements.

23. A computer program product comprising code means for producing the steps of claim 21 or 22 when run on a computer device.

24. A bit stream (34) generated by the method of claim 21 and comprising at least one descriptive prompt (342) representing a compressed semantic object belonging to a data object type that can be represented or reconstructed by means of the descriptive prompt (342) and a compression model (322).
